# EUROPEAN PATENT APPLICATION

(11) **EP 4 797 918 A1**
(43) Date of publication of application: **26.08.2026**
(21) Application number: 24879965.2
(22) Date of filing: 12.09.2024
(51) Int. Cl.: H10K 59/121, H10K 59/12, H10D 64/27, H10D 30/67, H10D 48/00

(54) **DISPLAY DEVICE AND MANUFACTURING METHOD THEREFOR**

(30) Priority: 20.10.2023 KR 20230141321
(71) Applicant: Samsung Display Co., Ltd., Yongin-si, Gyeonggi-do 17113 (KR)
(72) Inventor: YI, Chang Ho, Yongin-si Gyeonggi-do 17113 (KR); YOON, Joo Sun, Yongin-Si Gyeonggi-do 17113 (KR)
(74) Representative: Marks & Clerk LLP
(86) International application number: PCT/KR2024/013862
(87) International publication number: WO 2025/084626

(57) **Abstract**

This display device comprises: a substrate; a first transistor which is disposed on the substrate, and which includes a first active layer that includes a first portion including a first channel region, and a second portion and a third portion spaced apart from each other with the first portion interposed therebetween, and a first gate electrode that is disposed on the first portion of the first active layer; at least one first dummy gate electrode disposed on a part of the second portion and/or the third portion of the first active layer, and separated from the first gate electrode; and a first gate insulation layer disposed between the first active layer and each of the first gate electrode and the at least one first dummy gate electrode.

## Description

### [Technical Field]

Embodiments of the present disclosure relate to a display device and a method for manufacturing the same.

### [Background Art]

The importance of display devices has steadily increased with the development of multimedia technology. Accordingly, various types of display devices such as a liquid crystal display device or a light emitting display device have been developed.

### [Detailed Description of the Invention]

### [Technical Problem]

The problem to be solved by the present disclosure is to provide a display device capable of making the operating characteristics of a transistor uniform and improving image quality, and a method for manufacturing the same.

The tasks of the present invention are not limited to the tasks mentioned above, and other technical tasks not mentioned will be clearly understood by those skilled in the art from the description below.

### [Technical Solution]

A display device according to an embodiment may include a substrate, a first transistor including a first active layer disposed on the substrate and including a first portion including a first channel region and a second portion and a third portion spaced apart from each other with the first portion interposed therebetween, and a first gate electrode disposed on the first portion of the first active layer, at least one first dummy gate electrode disposed on a part of at least one of the second portion and the third portion of the first active layer and separated from the first gate electrode, and a first gate insulating layer disposed between the first active layer and each of the first gate electrode and the at least one first dummy gate electrode.

In an embodiment, the first gate insulating layer may include an insulating pattern disposed between the first active layer and the first gate electrode and may expose a part of each of the second portion and the third portion of the first active layer.

In an embodiment, the first gate insulating layer may further include at least one insulating pattern disposed between the at least one first dummy gate electrode and the first active layer.

In an embodiment, the first active layer may further include a first source region located in the second portion and located at a side of the first channel region, and a first drain region located in the third portion and located at another side of the first channel region, and the first gate electrode may cover at least the first channel region and may overlap a part of the first source region and a part of the first drain region by a section corresponding to a first length in a longitudinal direction of the first active layer.

In an embodiment, the first dummy gate electrode may have a length less than or equal to the first length in the longitudinal direction of the first active layer.

In an embodiment, the first dummy gate electrode may have a length longer than the first length in the longitudinal direction of the first active layer, and the first active layer may further include at least one dummy channel region located in at least one of the second portion and the third portion and overlapping the first dummy gate electrode.

In an embodiment, the first dummy gate electrode may cover the dummy channel region and overlap a part of the first source region or a part of the first drain region around the dummy channel region.

In an embodiment, the dummy channel region may have a short channel whose length falls within a threshold voltage roll-off section of a dummy transistor including the first dummy gate electrode and the dummy channel region.

In an embodiment, the display device may further include a pixel including a plurality of pixel transistors including the first transistor, and the dummy channel region may have a length shorter than a length of a channel region of each of the plurality of pixel transistors.

In an embodiment, the display device may further include an interlayer insulating layer disposed on the substrate, and covering the first active layer, the first gate insulating layer, the first gate electrode and the at least one dummy gate electrode, and the first transistor may further include at least one of a first source electrode disposed on the interlayer insulating layer and electrically connected to the first source region, and a first drain electrode disposed on the interlayer insulating layer and electrically connected to the first drain region.

In an embodiment, the display device may further include a power line electrically connected to the first dummy gate electrode and to which a gate-on voltage of the first transistor is applied.

In an embodiment, the display device may further include a pixel including a pixel circuit including the first transistor and a light emitting element connected to the pixel circuit, and the first transistor may be a driving transistor which controls a driving current flowing to the light emitting element in response to a voltage applied to the first gate electrode.

In an embodiment, the at least one first dummy gate electrode may include a plurality of first dummy gate electrodes, and the plurality of first dummy gate electrodes may be located at both sides of the first gate electrode and disposed above each of the second portion and the third portion of the first active layer.

In an embodiment, the pixel circuit may further include a second transistor electrically connected to the first gate electrode, and the second transistor may include a second active layer disposed on the substrate and including a first portion including a second channel region, a second portion located at a side of the second channel region and including a second source region, and a third portion located at another side of the second channel region and including a second drain region, and a second gate electrode disposed on the first portion of the second active layer.

In an embodiment, the pixel may further include at least one second dummy gate electrode disposed on a part of at least one of the second portion and the third portion of the second active layer, and spaced apart from the second gate electrode, and a second gate insulating layer including insulating patterns disposed between the second active layer and each of the second gate electrode and the at least one second dummy gate electrode.

In an embodiment, the second gate insulating layer may expose a part of each of the second portion and the third portion of the second active layer, and the second gate electrode may cover at least the second channel region and overlap a part of each of the second source region and the second drain region around the second channel region.

In an embodiment, the at least one second dummy gate electrode may include a plurality of second dummy gate electrodes, and the plurality of second dummy gate electrodes may be located at both sides of the second gate electrode and disposed above each of the second portion and the third portion of the second active layer.

In an embodiment, the second source region may be electrically connected to the first gate electrode, and the pixel may include a single second dummy gate electrode disposed only on the second portion of the second active layer.

In an embodiment, the first active layer and the second active layer may contain an oxide semiconductor.

A method for manufacturing a display device according to according to an embodiment may include forming an active layer containing an oxide semiconductor on a substrate, forming a gate insulating layer covering the active layer on the substrate, forming, on the gate insulating layer, a gate electrode and at least one dummy gate electrode which overlap different parts of the active layer and are separated from each other, by etching the gate insulating layer, forming insulating patterns under each of the gate electrode and the at least one dummy gate electrode, and exposing a part of the active layer which does not overlap the gate electrode and the at least one dummy gate electrode, and forming an interlayer insulating layer covering the active layer, the insulating patterns, the gate electrode and the at least one dummy gate electrode.

Other details of the embodiments are included in the detailed description and the drawings.

### [Effects of the Invention]

A display device according to embodiments includes a transistor including an active layer and a gate electrode disposed on a part of the active layer, a dummy gate electrode disposed on the active layer and separated from the gate electrode, and a gate insulating layer disposed between each of the gate electrode and the dummy gate and the active layer. A method for manufacturing a display device according to embodiments includes forming the active layer, the gate electrode, the dummy gate electrode, and the gate insulating layer.

In accordance with the display device and the method for manufacturing the same according to embodiments, it is possible to reduce the amount of diffusion of oxygen vacancies diffused to a part of the active layer located under the gate electrode in the manufacturing process of the display device and/or the length of the region where the oxygen vacancies diffuses under the gate electrode. Therefore, the overlapping area between the source and/or drain regions of the transistor and the gate electrode may be reduced, and the parasitic capacitance of the transistor may be reduced. Accordingly, the operating characteristics of the transistor may become uniform and/or stable.

In some embodiments, the transistor may be a driving transistor of a pixel, or a switching transistor connected to the gate electrode of the driving transistor. In some embodiments, at least one dummy gate electrode may be formed above each of the active layers of at least one switching transistor and the driving transistor of the pixel. According to embodiments, it is possible to prevent, reduce, or minimize image stains due to the luminance variation of the pixels, and to improve the image quality of the display device.

The effects according to the embodiments are not limited to the contents exampled above, and more diverse effects are included in the present disclosure.

### [Brief Description of the Drawings]

FIG. 1 is a plan view illustrating a display device according to one embodiment;
FIG. 2 is a plan view illustrating a display panel of FIG. 1;
FIG. 3 is an equivalent circuit diagram illustrating a pixel according to one embodiment;
FIG. 4 is an equivalent circuit diagram illustrating the pixel according to one embodiment;
FIG. 5 is a plan view showing a pixel transistor and a dummy gate electrode according to one embodiment;
FIG. 6 is a cross-sectional view illustrating the display panel according to one embodiment;
FIG. 7 is a cross-sectional view illustrating the display panel according to one embodiment;
FIG. 8 is a plan view showing the pixel transistor and the dummy gate electrode according to one embodiment;
FIG. 9 is a cross-sectional view illustrating the display panel according to one embodiment;
FIG. 10 is a cross-sectional view illustrating the display panel according to one embodiment;
FIGS. 11 to 18 are cross-sectional views illustrating a method for manufacturing the display device according to one embodiment;
FIG. 19 is a cross-sectional view illustrating the display panel according to one embodiment; and
FIG. 20 is a cross-sectional view illustrating the display panel according to one embodiment.

### [Mode for Invention]

Advantages and features of the present disclosure and methods of accomplishing the same may be understood more readily by reference to the following detailed description of embodiments and the accompanying drawings. The present disclosure may, however, be embodied in many different forms and should not be construed as being limited to the embodiments set forth herein. Rather, these embodiments are provided so that this disclosure will be thorough and complete and will fully convey the concept of the present disclosure to those skilled in the art, and the present disclosure will only be defined by the appended claims.

It will be understood that when an element or layer is referred to as being "on" another element or layer, the element or layer can be directly on another element or layer or intervening elements or layers. Like reference numerals refer to like elements throughout the specification. Shapes, sizes, ratios, angles, numbers, etc. disclosed in the drawings for describing embodiments are merely an example, and the present disclosure is not limited to the illustrated details.

Features of various embodiments of the present disclosure may be partially or entirely coupled to or combined with each other, and may be inter-operated and driven in technically various ways. The embodiments may be implemented independently from each other, or may be implemented together in a co-dependent relationship.

Hereinafter, specific embodiments will be described with reference to the accompanying drawings.

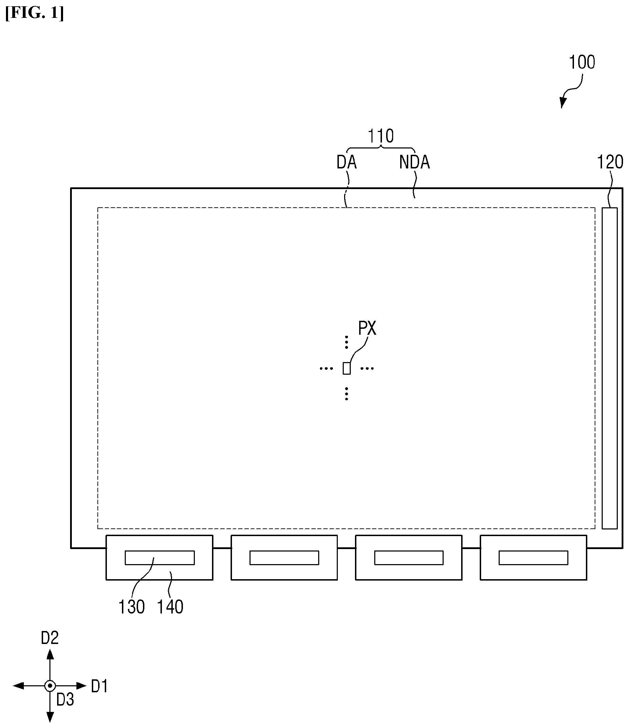

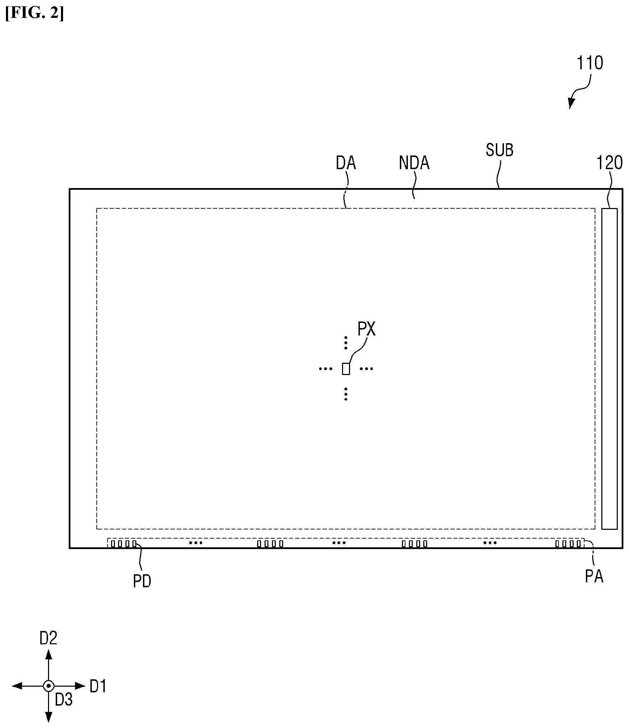

FIG. 1 is a plan view illustrating a display device 100 according to one embodiment. FIG. 2 is a plan view illustrating a display panel 110 of FIG. 1.

Referring to FIGS. 1 and 2, the display device 100 is a device for displaying a moving image or a still image. The display device 100 may be used as a display screen of various devices, such as a television, a laptop computer, a monitor, a billboard and an Internet-of-Things (IOT) device, as well as portable electronic devices such as a mobile phone, a smartphone, a tablet personal computer (PC), a smart watch, a watch phone, a mobile communication terminal, an electronic notebook, an electronic book, a portable multimedia player (PMP), a navigation device and an ultra-mobile PC (UMPC). These are presented as nothing more than examples, and the display device 100 may be applicable to various other types of electronic devices.

In one embodiment, the display device 100 may be a light emitting display device such as an organic light emitting display including an organic light emitting diode, a quantum dot light emitting display including a quantum dot light emitting layer, an inorganic light emitting display including an inorganic semiconductor, or an ultra-small light emitting display using an ultra-small light emitting diode such as a micro or nano light emitting diode (micro LED or nano LED), but is not limited thereto. For example, the display device 100 may be another type of display device other than a light emitting display device. In the following, embodiments in which the display device 100 is an organic light emitting display device will be disclosed.

The display device 100 may include the display panel 110 including pixels PX, and a first driver 120 and a second driver 130 configured to supply driving signals to the pixels PX. The display device 100 may further include additional components. For example, the display device 100 may further include a power supply unit for supplying power voltages to the pixels PX, the first driver 120, and the second driver 130, and a timing controller for controlling the operations of the first driver 120 and the second driver 130.

The display panel 110 may include a display area DA and a non-display area NDA (also referred to as a "bezel area"). The display area DA may be an area including the pixels PX to display an image. The non-display area NDA is an area other than the display area DA, and an image may not be displayed in the non-display area NDA. In one embodiment, the non-display area NDA may be positioned around the display area DA and may surround the display area DA.

In FIGS. 1 and 2, a first direction D1, a second direction D2, and a third direction D3 are defined. In one embodiment, the first direction D1 and the second direction D2 may be perpendicular to each other, the first direction D1 and the third direction D3 may be perpendicular to each other, and the second direction D2 and the third direction D3 may be perpendicular to each other. For example, the first direction D1 may be the horizontal direction (for example, a row direction or X direction) of the display panel 110, and the second direction D2 may be the vertical direction (for example, a column direction or Y direction) of the display panel 110. The third direction D3 may be the thickness direction (for example, a height direction or Z direction) of the display panel 110.

In one embodiment, the display panel 110 may have a rectangular shape in plan view. For example, the display panel 110 may include two first sides extending in the first direction D1 and two second sides extending in the second direction D2 intersecting the first direction D1. Although FIGS. 1 and 2 illustrate the display panel 110 in which the first side in the horizontal direction is longer than the second side in the vertical direction, the shape of the display panel 110 is not limited thereto. For example, the display panel 110 may have a shape in which the second side in the vertical direction is longer than the first side in the horizontal direction, or the lengths of the first side and the second side are substantially the same.

In one embodiment, the display panel 110 may include an angled corner at a portion where the first side and the second side meet, but the present disclosure is not limited thereto. For example, the display panel 110 may include a rounded corner at a portion where the first side and the second side meet.

The planar shape of the display panel 110 is not limited to the illustrated rectangular shape, and it may be applied in other shapes. For example, the display panel 110 may have a square shape, a non-quadrilateral polygonal shape, a circular shape, an elliptical shape, an atypical shape, or another shape in plan view.

In one embodiment, the display panel 110 may be substantially flat on the plane defined by the first direction D1 and the second direction D2, and may have a uniform thickness in the third direction D3. In another embodiment, the display panel 110 may be provided in a three-dimensional shape having a curved surface or the like.

The display panel 110 may be provided as a panel having rigid characteristics so as not to be substantially deformed, or as a panel having flexible characteristics that can be transformed to be at least partially folded, bent, or rolled. The display panel 110 may be provided to the display device 100 without bending, or may be provided to the display device 100 while being partially bent.

The display panel 110 may include a substrate SUB and pixels PX disposed on the substrate SUB. The pixels PX may be disposed in the display area DA on the substrate SUB.

The substrate SUB, which is a base member for manufacturing or providing the display panel 110, may form the base surface of the display panel 110. The substrate SUB may include the display area DA and the non-display area NDA located around the display area DA.

The display area DA may have various shapes depending on embodiments. For example, the display area DA may have a quadrilateral shape, a non-quadrilateral polygonal shape, a circular shape, an elliptical shape, an atypical shape, or another shape. In one embodiment, the display area DA may have a shape corresponding to the shape of the display panel 110, but the present disclosure is not limited thereto.

The display area DA may include pixel areas where the pixels PX are provided and/or disposed. For example, each pixel PX may be disposed in each pixel area located in the display area DA. In one embodiment, the display device 100 may be a light emitting display device, and each pixel PX may include a light emitting element located in each emission area and a pixel circuit connected to the light emitting element. In describing embodiments, the term "connect" may include electrical connection and/or physical connection. In addition, unless otherwise specified as "direct connection" or "indirect connection", the term "connection" may encompass both direct and indirect connections.

Each pixel area may include an emission area where the light emitting element of the corresponding pixel is located and where the pixel emits light, and a pixel circuit area where circuit elements constituting the pixel circuit of the corresponding pixel are located. The emission area and the pixel circuit area of each pixel PX may overlap each other, but the present disclosure is not limited thereto.

The pixels PX may be arranged in the display area DA. The arrangement type of the pixels PX may be variously changed depending on embodiments.

The non-display area NDA may include a pad area PA where pads PD are disposed, and may selectively further include a driving circuit area located on at least one side of the display area DA. At least one driver, the pads PD, and/or wires may be disposed in the non-display area NDA.

At least one driver for driving the pixels PX, or a part of the driver may be disposed in the driving circuit area. For example, the circuit elements constituting the first driver 120 may be disposed in the driving circuit area on the substrate SUB. In one embodiment, the circuit elements of the first driver 120 may be formed in the display panel 110 together with the pixels PX.

The pads PD may be disposed in the pad area PA. At least one circuit board 140 may be disposed and/or bonded on the pad area PA. In one embodiment, a plurality of circuit boards 140 connected to different pads PD may be disposed on the pad area PA. The pads PD may include signal pads and power pads for transmitting driving signals and power voltages required for driving the pixels PX and/or the first driver 120 into the display panel 110.

The first driver 120 and the second driver 130 may generate driving signals for controlling operation timing, luminance, and the like of the pixels PX, and may supply the generated driving signals to the pixels PX. For example, the first driver 120 may be a gate driver including a scan driver, and may be connected to the pixels PX through respective gate lines. The first driver 120 may supply respective gate signals (e.g., driving signals for controlling the operation timing of the pixels PX) to the pixels PX. The second driver 130 may be a data driver including source driving circuits, and may be connected to the pixels PX through respective data lines. The second driver 130 may supply respective data signals to the pixels PX.

In one embodiment, at least one first driver of the first driver 120 or the second driver 130 (or a part of the at least one first driver) may be embedded in the display panel 110. For example, the first driver 120 may be disposed on the substrate SUB of the display panel 110 and may be disposed and/or formed in the non-display area NDA.

Although FIG. 1 illustrates that the first driver 120 is formed on one side of the display area DA (for example, in the non-display area NDA on the right side of the display area DA), but the embodiments are not limited thereto. For example, the first driver 120 may be positioned only on the other side (e.g., the non-display area NDA on the left side of the display area DA) of the display area DA, or may be positioned on both sides (e.g., the non-display area NDA on the left side and right side of the display area DA) of the display area DA. Alternatively, a part of the first driver 120 may be located in the non-display area NDA, and the other part of the first driver 120 may be located in a non-emission area (e.g., area between the emission areas of the pixels PX) in the display area DA.

In one embodiment, the other driver of the first driver 120 and the second driver 130 (or a part of the other driver) may be disposed or formed outside the display panel 110 to be electrically connected to the display panel 110. For example, the second driver 130 may be implemented as a plurality of integrated circuit chips, and may be disposed on the circuit boards 140 electrically connected to the pixels PX of the display panel 110. Alternatively, the second driver 130 may be implemented as at least one integrated circuit chip and mounted on the non-display area NDA of the display panel 110.

The circuit board 140 may be connected to the display panel 110 through the pads PD. In one embodiment, the circuit board 140 may be a flexible film such as a flexible printed circuit board (FPCB), a printed circuit board (PCB), or a chip on film (COF), but is not limited thereto. The circuit board 140 may be connected to the timing controller and/or the power supply unit through another circuit board, connector, or the like.

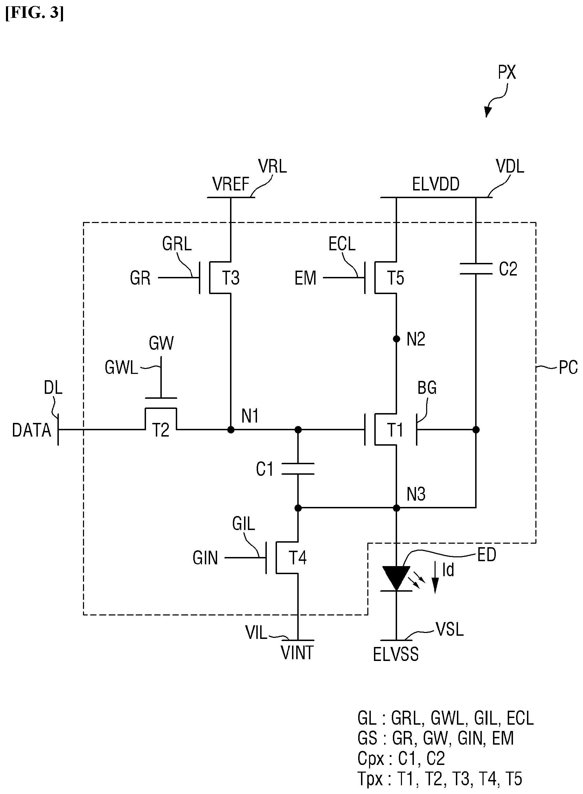

FIG. 3 is an equivalent circuit diagram illustrating the pixel PX according to one embodiment. The pixel PX of FIG. 3 is merely presented as one example, and the structure or type of the pixel PX may be variously changed according to embodiments.

Referring to FIG. 3 in addition to FIGS. 1 and 2, the pixel PX may include a light emitting element ED, and a pixel circuit PC connected to (e.g., electrically connected to) the light emitting element ED. The light emitting element ED is a light source of the pixel PX, and it may be, for example, an organic light emitting diode, but is not limited thereto. The pixel circuit PC may control the emission time point and the luminance of the light emitting element ED.

The pixel circuit PC may include pixel transistors Tpx and at least one pixel capacitor Cpx. For example, the pixel circuit PC may include first to fifth transistors T1 to T5, and first and second capacitors C1 and C2. The structure of the pixel circuit PC or the types of the circuit elements constituting the pixel circuit PC may be changed in various ways according to embodiments. Although FIG. 3 illustrates an embodiment in which the pixel transistors Tpx are all N-type transistors, the types of pixel transistors Tpx are not limited thereto. For example, at least one pixel transistor Tpx may be formed as a P-type transistor.

The pixel circuit PC may supply a driving current Id to the light emitting element ED in response to the driving signals supplied from the first driver 120 and the second driver 130. For example, the pixel circuit PC may supply the driving current Id to the light emitting element ED in response to respective gate signals GS supplied from the first driver 120 through respective gate lines GL and a data signal DATA supplied from the second driver 130 through a data line DL.

The first transistor T1 may be a driving transistor of the pixel PX whose magnitude of drain-source current (e.g., the driving current Id) is determined depending on the gate-source voltage. The second, third, fourth, and fifth transistors T2, T3, T4, and T5 may be switching transistors that are turned on or off in response to respective gate-source voltages. Depending on the type (for example, P-type or N-type) and/or operating conditions of each of the first to fifth transistors T1 to T5, a first electrode of each of the first to fifth transistors T1 to T5 may be a drain electrode (or a drain region), or a source electrode (or a source region), and a second electrode thereof may be an electrode different from the first electrode. For example, when the first electrode is a drain electrode, the second electrode may be a source electrode.

The pixel PX may be connected to a first gate line GWL that transmits the first gate signal GW (e.g., a scan signal), a second gate line GIL that transmits a second gate signal GIN, a third gate line GRL that transmits a third gate signal GR, an emission control line ECL that transmits an emission control signal EM, and the data line DL that transmits the data signal DATA. Further, the pixel PX may be connected to a first power line VDL that transmits a first pixel voltage ELVDD (also referred to as "first pixel power voltage"), and a second power line VSL that transmits a second pixel voltage ELVSS (also referred to as "second pixel power voltage"). In one embodiment, the pixel PX may be further connected to an initialization power line VIL that transmits an initialization voltage VINT (also referred to as "third pixel power voltage"), and a reference power line VRL that transmits a reference voltage VREF (also referred to as "fourth pixel power voltage").

In one embodiment, the first to fifth transistors T1 to T5 may be located in each pixel area, and may be oxide transistors (also referred to as "oxide semiconductor transistors") including an oxide semiconductor (e.g., an oxide semiconductor material). By way of example, an active layer including a channel region of each of the first to fifth transistors T1 to T5 may be formed of the oxide semiconductor. However, the embodiments are not limited thereto. For example, at least one pixel transistor Tpx may be formed of a semiconductor material (for example, amorphous silicon or polysilicon) other than an oxide semiconductor.

The oxide semiconductor may have high carrier mobility and a low leakage current, so that a considerable voltage drop may not occur even if the driving time of the oxide transistor increases. For example, the pixel PX including an oxide transistor may be driven at a low frequency because the change in the luminance and/or the color of an image due to a voltage drop is not significant even when it is driven at a low frequency. In the case of the display device 100 in which the first to fifth transistors T1 to T5 include an oxide semiconductor, the leakage current of the pixel PX may be reduced or prevented and the power consumption may be reduced.

The oxide semiconductor is sensitive to light, so that the amount of current or the like may be changed due to external light. In one embodiment, a light blocking pattern or a lower electrode (e.g., a bottom gate electrode) may be disposed under the active layer included in at least one pixel transistor Tpx to block external light. Accordingly, the operating characteristics of the pixel transistor Tpx may become stable.

The first transistor T1 (also referred to as "first pixel transistor") may include a gate electrode connected to a first node N1, a first electrode (for example, a drain electrode) connected to a second node N2, and a second electrode (for example, a source electrode) connected to a third node N3. The first electrode of the first transistor T1 may be connected to the first power line VDL via the fifth transistor T5, and the second electrode thereof may be connected to the light emitting element ED. The first transistor T1 may function as a driving transistor of the pixel PX, and may control the magnitude (for example, the amount of current) of the driving current Id flowing to the light emitting element ED in response to the data signal DATA transmitted to the first node N1.

In one embodiment, the first transistor T1 may further include a bottom gate electrode BG (e.g., the back-gate electrode of the first transistor T1) connected to the third node N3. In the case of forming the first transistor T1 as a transistor having a double gate structure (e.g., a double gate electrode having a source-sync structure) by connecting the bottom gate electrode BG of the first transistor T1 to the third node N3, the operating characteristics of the first transistor T1 may be improved.

The second transistor T2 (also referred to as "second pixel transistor") may include a gate electrode connected to the first gate line GWL, a first electrode connected to the data line DL, and a second electrode connected to the first node N1. The second transistor T2 may be turned on by the first gate signal GW (for example, the first gate signal GW of the gate-on voltage) transmitted to the first gate line GWL to connect the data line DL and the first node N1. Accordingly, the data signal DATA transmitted through the data line DL may be sent to the first node N1.

The third transistor T3 (also referred to as " third pixel transistor") may include a gate electrode connected to the third gate line GRL, a first electrode connected to the reference power line VRL, and a second electrode connected to the first node N1. The third transistor T3 may be turned on by the third gate signal GR transmitted through the third gate line GRL and transmit the reference voltage VREF transmitted to the reference power line VRL to the first node N1.

The fourth transistor T4 (also referred to as "fourth pixel transistor") may include a gate electrode connected to the second gate line GIL, a first electrode connected to the third node N3, and a second electrode connected to the initialization power line VIL. The fourth transistor T4 may be turned on by the second gate signal GIN transmitted through the second gate line GIL and transmit the initialization voltage VINT transmitted to the initialization power line VIL to the third node N3.

The fifth transistor T5 (also referred to as "fifth pixel transistor") may include a gate electrode connected to the emission control line ECL, a first electrode connected to the first power line VDL, and a second electrode connected to the second node (or the first electrode of the first transistor T1). The fifth transistor T5 may be turned on by the emission control signal EM (for example, the emission control signal EM of the gate-on voltage) transmitted to the emission control line ECL to control the emission time point of the pixel PX.

The first capacitor C1 may be connected between the first node N1 and the third node N3. For example, the first capacitor C1 may be connected between the second electrode and the gate electrode of the first transistor T1. The first capacitor C1 is a storage capacitor of the pixel PX, and may store therein a threshold voltage of the first transistor T1 and a voltage corresponding to the data signal DATA (e.g., a data voltage).

The second capacitor C2 may be connected between the first power line VDL and the third node N3. In one embodiment, the capacity of the second capacitor C2 may be less than that of the first capacitor C1.

The light emitting element ED may be connected between the third node N3 and the second power line VSL. For example, the light emitting element ED may include a first electrode (e.g., an anode electrode) connected to the third node N3, a second electrode (e.g., a cathode electrode) facing the first electrode and connected to the second power line VSL, and a light emitting layer disposed between the first electrode and the second electrode. In one embodiment, the first electrode of the light emitting element ED may be an individual electrode individually provided in each pixel PX, and the second electrode of the light emitting element ED may be a common electrode shared by a plurality of pixels PX. The light emitting element ED may emit light with a luminance corresponding to the driving current Id during a time period in which the driving current Id is supplied from the pixel circuit PC.

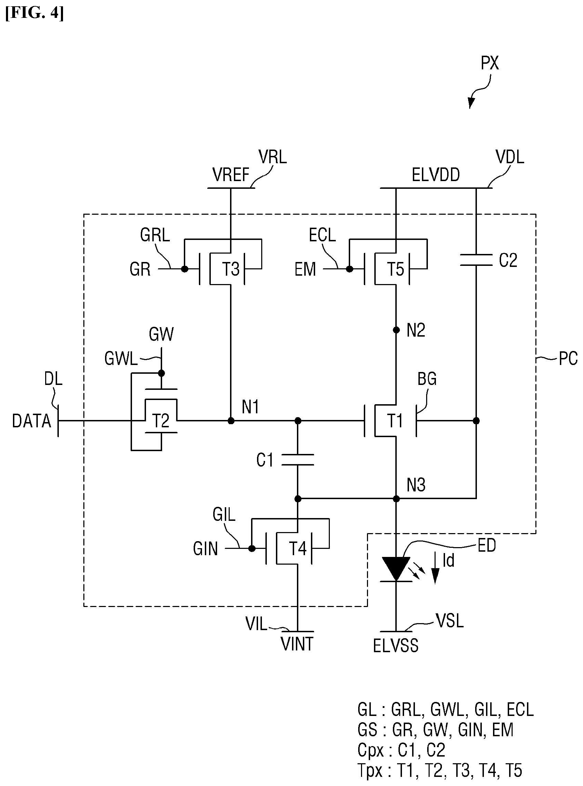

FIG. 4 is an equivalent circuit diagram illustrating the pixel PX according to one embodiment. For example, FIG. 4 shows an additional embodiment related to switching transistors among the pixel transistors Tpx of FIG. 3.

Referring to FIG. 4 in addition to FIGS. 1 to 3, at least one of the switching transistors provided in the pixel PX may include the bottom gate electrode BG (or the back-gate electrode) facing the gate electrode (e.g., a top gate electrode) with the active layer interposed therebetween. For example, at least one of the second, third, fourth, and fifth transistors T2, T3, T4, and T5 may include the bottom gate electrode BG.

FIG. 4 shows an embodiment in which the bottom gate electrodes BG are provided in all the pixel transistors Tpx, and only the bottom gate electrode BG provided in one pixel transistor Tpx (e.g., the first transistor T1) is denoted by a notation. However, the embodiments are not limited thereto. For example, at least one pixel transistor Tpx may not include the bottom gate electrode BG, and/or may not be formed as a double gate transistor having a gate-sync or source-sync structure.

In one embodiment, the second, third, fourth, and fifth transistors T2, T3, T4, and T5 may include the respective bottom gate electrodes BG connected to the respective gate electrodes. For example, each of the second, third, fourth, and fifth transistors T2, T3, T4, and T5 may be formed as a double gate transistor having a gate-sink structure.

By providing the respective bottom gate electrodes BG in the second, third, fourth, and fifth transistors T2, T3, T4, and T5, it is possible to prevent or reduce the change in the amount of current of the second, third, fourth, and fifth transistors T2, T3, T4, and T5. Further, when the respective bottom gate electrodes BG of the second, third, fourth, and fifth transistors T2, T3, T4, and T5 are connected to the respective gate electrodes of the second, third, fourth, and fifth transistors T2, T3, T4, and T5, the operating characteristics (e.g., switching characteristics) of the second, third, fourth, and fifth transistors T2, T3, T4, and T5 may be improved and/or stabilized. For example, since at least one switching transistor is formed in a double gate structure of a gate-sink structure, it is possible to improve the off characteristics and the switching speed of the switching transistor, secure an additional voltage tolerance range, lower a leakage current, and improve voltage stability. For example, since a small-sized switching transistor formed of an oxide transistor with a short channel length is formed in a double gate structure of a gate-sink structure, the operating characteristics of the switching transistor may be improved.

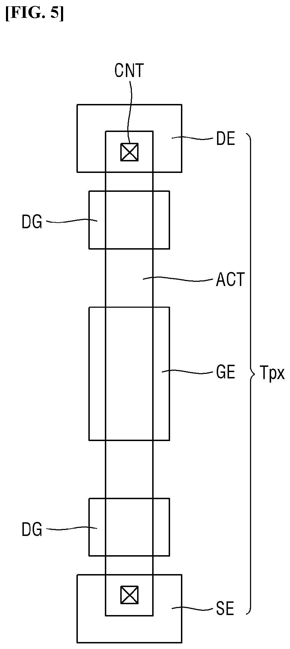

FIG. 5 is a plan view showing the pixel transistor Tpx and a dummy gate electrode DG according to one embodiment. FIG. 5 shows a schematic planar shape of one pixel transistor Tpx representing the pixel transistors Tpx, and the shape and/or size of each pixel transistor Tpx may be variously changed depending on embodiments.

Referring to FIG. 5 in addition to FIGS. 1 to 4, the pixel transistor Tpx may include an active layer ACT and a gate electrode GE disposed on a part of the active layer ACT. In one embodiment, the gate electrode GE may be the top gate electrode disposed on the active layer ACT, and a gate insulating layer may be disposed between the active layer ACT and the gate electrode GE.

In one embodiment, the pixel transistor Tpx may further include a source electrode SE and a drain electrode DE that are disposed on different parts of the active layer ACT and connected to different parts (e.g., a part including a source region and a part including a drain region) of the active layer ACT through respective contact holes CNT. In FIG. 5, only one contact hole CNT is denoted by a notation.

In one embodiment, at least one of the pixel transistors Tpx provided in the pixel PX may not include a separate source electrode SE and/or a separate drain electrode DE. For example, the source region and/or the drain region included in the active layer ACT of the at least one pixel transistor Tpx may be connected to (e.g., directly connected to) another circuit element, wire, and/or conductive pattern.

In one embodiment, at least one pixel transistor Tpx may further include the bottom gate electrode BG, as in the embodiment of FIG. 3 or FIG. 4. For example, at least one pixel transistor Tpx may further include the bottom gate electrode BG that is disposed under the active layer ACT and faces the gate electrode GE with the active layer ACT interposed therebetween.

At least one dummy gate electrode DG separated from and/or spaced apart from the gate electrode GE may be disposed on the active layer ACT of at least one pixel transistor Tpx. For example, two dummy gate electrodes DG disposed on different parts of the active layer ACT and spaced apart from the gate electrode GE may be disposed on both sides of the gate electrode GE of at least one pixel transistor Tpx including the first transistor T1.

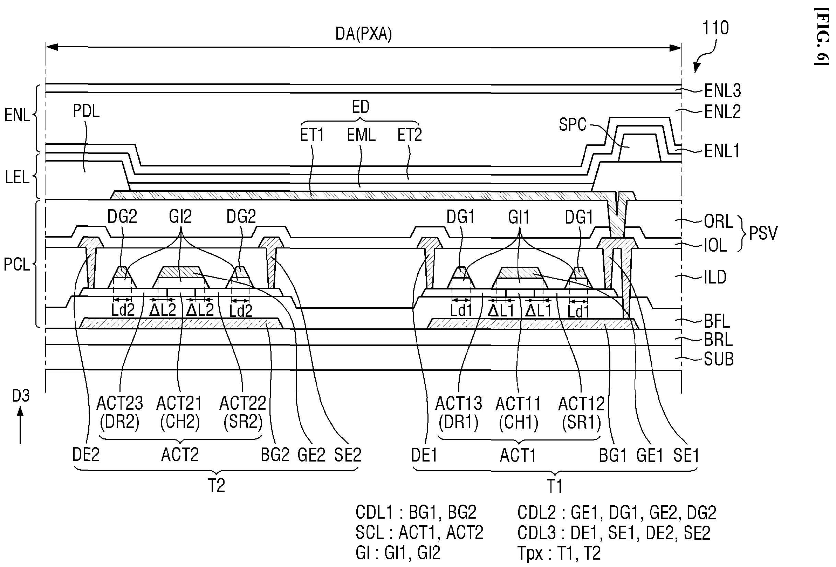

FIG. 6 is a cross-sectional view illustrating the display panel 110 according to one embodiment. For example, FIG. 6 shows a part of the display area DA of the display panel 110.

FIG. 6 illustrates the first transistor T1 and the second transistor T2 disposed in one pixel area PXA as an example of circuit elements that may be provided or disposed in a panel circuit layer PCL of the display panel 110. In addition, FIGS. 5 and 6 show a light emitting display panel including the light emitting element ED (for example, an organic light emitting diode) as an example of the display panel 110 to which embodiments may be applied. However, the type and/or structure of the display panel 110 are not limited thereto. For example, the display panel 110 may include a light emitting element of another type and/or structure, or may be a display panel of another type and/or structure other than the light emitting display panel.

Referring to FIG. 6 in addition to FIGS. 1 to 5, the display panel 110 may include the substrate SUB (also referred to as "base member" or "base layer"), the panel circuit layer PCL, a light emitting element layer LEL, and an encapsulation layer ENL. The panel circuit layer PCL, the light emitting element layer LEL, and the encapsulation layer ENL may be disposed or provided to overlap each other on the substrate SUB. In one embodiment, the panel circuit layer PCL, the light emitting element layer LEL, and the encapsulation layer ENL may be sequentially arranged or formed on the substrate SUB along the third direction D3.

In one embodiment, the display panel 110 may further include additional elements disposed above and/or under the encapsulation layer ENL. For example, the display panel 110 may further include at least one of a sensor layer (for example, a touch sensor layer), an optical layer (for example, a color filter layer and/or a wavelength conversion layer), or a passivation layer (for example, a passivation film, an insulating layer, an upper substrate, and/or a window). Each of the sensor layer, the optical layer, and/or the passivation layer may be disposed above the encapsulation layer ENL or may be disposed between the light emitting element layer LEL and the encapsulation layer ENL.

The substrate SUB, which is a base member for forming the display panel 110, may be a substrate (or film) having rigid or flexible characteristics. In one embodiment, the substrate SUB may be a substrate including an insulating material such as glass or the like and having rigid characteristics, and may not be bent. In another embodiment, the substrate SUB may be a flexible substrate that includes polyimide or another insulating material and may be transformed to be bent, folded, or rolled, and may or may not be bent. The type and/or material of the substrate SUB may change depending on embodiments.

The substrate SUB may include at least the display area DA. In one embodiment, the display area DA may include the pixel areas PXA corresponding to each of the pixels PX. For example, in the display area DA, the respective pixel areas PXA in which each of the pixels PX is disposed may be defined.

In one embodiment, a barrier layer BRL may be provided on the substrate SUB. For example, the display panel 110 may further include the barrier layer BRL disposed between the substrate SUB and the panel circuit layer PCL. In another embodiment, the display panel 110 may not include the barrier layer BRL, and in this case, the panel circuit layer PCL may be disposed on (e.g., directly disposed on) the substrate SUB.

The barrier layer BRL may include at least one inorganic insulating layer containing an inorganic insulating material (e.g., silicon nitride, silicon oxide, silicon oxynitride, titanium oxide, aluminium oxide, or another inorganic insulating material). The barrier layer BRL may protect the pixels PX from moisture permeating through the substrate SUB that is susceptible to moisture permeation. The material of the barrier layer BRL may be variously changed according to embodiments.

The panel circuit layer PCL may be disposed on one surface of the substrate SUB where the barrier layer BRL is provided. The panel circuit layer PCL may include circuit elements including the pixel transistors Tpx and the pixel capacitors Cpx, and wires (e.g., signal lines and power lines).

The panel circuit layer PCL may further include insulating layers disposed on the substrate SUB. For example, the panel circuit layer PCL may include a buffer layer BFL (also referred to as "first insulating layer"), a gate insulating layer GI (also referred to as "second insulating layer"), an interlayer insulating layer ILD (also referred to as "third insulating layer"), and a passivation layer PSV (also referred to as "fourth insulating layer") that are sequentially disposed on the substrate SUB along the third direction D3. In one embodiment, the buffer layer BFL, the interlayer insulating layer ILD, and the passivation layer PSV may be formed in the entire display area DA, and the gate insulating layer GI may be formed of insulating patterns locally disposed on a part of each of the active layers ACT of the pixel transistors Tpx.

In one embodiment, the passivation layer PSV may have a multilayer structure including an inorganic layer (for example, an inorganic insulating layer) and an organic layer (for example, an organic insulating layer). For example, the passivation layer PSV may include an inorganic layer IOL and an organic layer ORL sequentially disposed on the interlayer insulating layer ILD.

In one embodiment, the display panel 110 may further include an additional conductive layer and/or an additional passivation layer. For example, the display panel 110 may further include at least one fourth conductive layer provided on the passivation layer PSV, and at least one insulating layer that covers the fourth conductive layer. In an embodiment in which the display panel 110 further includes the fourth conductive layer, at least one wiring and/or bridge pattern (for example, bridge pattern connected between a first source electrode SE1 of the first transistor T1 and a first electrode ET1 of the light emitting element ED) or the like may be provided on the fourth conductive layer.

In one embodiment, each of the buffer layer BFL, the gate insulating layer GI, the interlayer insulating layer ILD, and the inorganic layer IOL may include at least one inorganic insulating layer containing an inorganic insulating material (e.g., silicon nitride, silicon oxide, silicon oxynitride, titanium oxide, aluminium oxide, or another inorganic insulating material).

The organic layer ORL may include at least one organic insulating layer containing an organic insulating material (e.g., acryl resin, epoxy resin, phenolic resin, polyamide resin, polyimide resin, or other organic insulating materials). The surface (for example, the top surface) of the organic layer ORL may be substantially flat.

The pixel transistors Tpx may be included in the pixel circuit PC of each pixel PX, and may be positioned in the display area DA. For example, the first transistor T1 and the second transistor T2 provided to (e.g., included in) each of the pixels PX may be disposed in each of the pixel areas PXA in which the corresponding pixel PX is positioned. In describing the embodiments, when a certain element is said to be "provided in" another element, it may mean that the certain element is included in or disposed inside the other element. Further, at least another pixel transistor Tpx and/or at least one pixel capacitor Cpx may be further disposed in each pixel area PXA.

In one embodiment, at least one pixel transistor Tpx may include the bottom gate electrode BG. For example, the first transistor T1 may include a first bottom gate electrode BG1, and the second transistor T2 may include a second bottom gate electrode BG2. In one embodiment, the first bottom gate electrode BG1 and the second bottom gate electrode BG2 may be provided in the same layer (e.g., a first conductive layer CDL1) within the panel circuit layer PCL.

The first transistor T1 may include the first bottom gate electrode BG1 disposed on the substrate SUB, a first active layer ACT1 (also referred to as "first active pattern") disposed on the first bottom gate electrode BG1, and a first gate electrode GE1 disposed on the first active layer ACT1. The buffer layer BFL may be disposed between the first bottom gate electrode BG1 and the first active layer ACT1. The first gate insulating layer GI1 may be disposed between the first active layer ACT1 and the first gate electrode GE1.

In one embodiment, the first transistor T1 may further include the first source electrode SE1 and a first drain electrode DE1 connected to different parts of the first active layer ACT1. Alternatively, the first transistor T1 may not include a separate source electrode and/or a separate drain electrode, and a first source region SR1 and/or a first drain region DR1 of the first active layer ACT1 may be connected to another circuit element, wire, and/or conductive pattern to function as the source electrode and/or the drain electrode of the first transistor T1.

The first bottom gate electrode BG1 may be provided in the first conductive layer CDL1 on the substrate SUB. For example, the first conductive layer CDL1 includes the first bottom gate electrode BG1 and may optionally further include additional conductive patterns. In one embodiment, the first conductive layer CDL1 may be disposed between the substrate SUB and the buffer layer BFL. For example, the first conductive layer CDL1 may be disposed on the barrier layer BRL and covered by the buffer layer BFL.

The first bottom gate electrode BG1 may overlap the first active layer ACT1. For example, the first bottom gate electrode BG1 may be disposed under the first active layer ACT1 to overlap at least a first channel region CH1. The first bottom gate electrode BG1 and the first active layer ACT1 may be spaced apart from each other with the buffer layer BFL interposed therebetween. The first bottom gate electrode BG1 may face the first gate electrode GE1 with the first active layer ACT1 interposed therebetween. In one embodiment, the first bottom gate electrode BG1 may be electrically connected to the first source electrode SE1, and may be utilized as a back-gate electrode that adjusts the characteristics of the first transistor T1.

The first active layer ACT1 may be provided in a semiconductor layer SCL on the substrate SUB. For example, the semiconductor layer SCL includes the first active layer ACT1 and may optionally further include additional semiconductor patterns. In one embodiment, the semiconductor layer SCL may be disposed on the buffer layer BFL, and may be covered by the gate insulating layer GI and the interlayer insulating layer ILD.

The first active layer ACT1 may include a first portion ACT11 located at the center, and a second portion ACT12 and a third portion ACT13 spaced apart from each other with the first portion ACT11 disposed between the second portion ACT12 and the third portion ACT13. For example, the second portion ACT12 and the third portion ACT13 of the first active layer ACT1 may be located on both sides of the first portion ACT11.

At least a part of the first active layer ACT1 including the first portion ACT11 may overlap the first bottom gate electrode BG1. The first portion ACT11 of the first active layer ACT1 may include the first channel region CH1. In one embodiment, the entire first portion ACT11 of the first active layer ACT1 may be the first channel region CH1. The first channel region CH1 may be a region that maintains semiconductor characteristics without becoming conductive.

The first active layer ACT1 may include the first source region SR1 and the first drain region DR1 located at the second portion ACT12 and the third portion ACT13, respectively. For example, the second portion ACT12 of the first active layer ACT1 may include the first source region SR1, and the third portion ACT13 of the first active layer ACT1 may include the first drain region DR1. In one embodiment, the entire second portion ACT12 of the first active layer ACT1 may be the first source region SR1, and the entire third portion ACT13 of the first active layer ACT1 may be the first drain region DR1. The first source region SR1 may be located on one side of the first channel region CH1, and the first drain region DR1 may be located on the other side of the first channel region CH1. The first source region SR1 and the first drain region DR1 may be spaced apart from each other with the first channel region CH1 interposed therebetween. The first source region SR1 and the first drain region DR1, which are regions that have become conductive, may have a carrier concentration (for example, electron concentration) higher than that of the first channel region CH1.

The first gate insulating layer GI1 may be disposed on a part of the first active layer ACT1. For example, the first gate insulating layer GI1 may be disposed between the first active layer ACT1 and the first gate electrode GE1, and between the first active layer ACT1 and first dummy gate electrodes DG1.

In one embodiment, the first gate insulating layer GI1 may have a shape that is etched to cover only a part of the first active layer ACT1 and expose the other part of the first active layer ACT1. For example, the first gate insulating layer GI1 may include an insulating pattern that is disposed between the first active layer ACT1 and the first gate electrode GE1 and covers at least the first portion ACT11 of the first active layer ACT1. For example, the first gate insulating layer GI1 may include an insulating pattern that is disposed under the first gate electrode GE1 and covers the first portion ACT11 of the first active layer ACT1 and a part of the second portion ACT12 and a part of the third portion ACT13 that are directly adjacent to the first portion ACT11. The first gate insulating layer GI1 may not be provided on another part of the second portion ACT12 and another part of the third portion ACT13 of the first active layer ACT1, and thus may expose another part of the second portion ACT12 and another part of the third portion ACT13 of the first active layer ACT1. The first gate insulating layer GI1 may further include at least one insulating pattern disposed between the first active layer ACT1 and at least one first dummy gate electrode DG1 disposed on the first active layer ACT1. For example, the first gate insulating layer GI1 may further include insulating patterns respectively disposed under the first dummy gate electrodes DG1 located on both sides of the first gate electrode GE1.

In one embodiment, the insulating patterns disposed on the first active layer ACT1 may be separated from each other. However, the embodiments are not limited thereto. For example, the first gate insulating layer GI1 may be formed of one connected insulating pattern in plan view and may have a shape that is etched to include an opening corresponding to a part of the second portion ACT12 and an opening corresponding to a part of the third portion ACT13 of the first active layer ACT1.

Since the first gate insulating layer GI1 exposes a part of the second portion ACT12 and a part of the third portion ACT13 of the first active layer ACT1, the first source region SR1 and the first drain region DR1 may become appropriately and/or easily conductive in the manufacturing process of the display panel 110. For example, the first gate insulating layer GI1 is formed by etching the gate insulating layer GI such that a part of the second portion ACT12 and a part of the third portion ACT13 of the first active layer ACT1 are exposed, and the interlayer insulating layer ILD is formed in a state where a part of the second portion ACT12 and a part of the third portion ACT13 of the first active layer ACT1 are exposed, so that the source region SR1 and the first drain region DR1 may become appropriately and/or easily conductive without performing a separate doping process.

The first gate electrode GE1 and first dummy gate electrodes DG1 may be disposed on the first gate insulating layer GI1. The first gate electrode GE1 and the first dummy gate electrodes DG1 may be provided in a second conductive layer CDL2 on the substrate SUB. For example, the second conductive layer CDL2 includes the first gate electrode GE1 and first dummy gate electrodes DG1 and may optionally further include additional conductive patterns. In one embodiment, the second conductive layer CDL2 may be disposed on the gate insulating layer GI, and may be covered by the interlayer insulating layer ILD.

The first gate electrode GE1 may be disposed on a portion of the first active layer ACT1 including the first portion ACT11. For example, the first gate electrode GE1 may be disposed on the first portion ACT11 of the first active layer ACT1 to overlap at least the first channel region CH1.

In one embodiment, the first gate electrode GE1 may also be disposed on a part of the second portion ACT12 and a part of the third portion ACT13 of the first active layer ACT1 to overlap a part of the first source region SR1 and a part of the first drain region DR1. For example, the first gate electrode GE1 may overlap the first source region SR1 and the first drain region DR1 by a section corresponding to a length ΔL1 (e.g., by the length of ΔL1) in a part of the first source region SR1 and a part of the first drain region DR1 that are in contact with the first channel region CH1. The section corresponding to the length ΔL1 in each of the first source region SR1 and the first drain region DR1 may diffuse to a part of the region where oxygen vacancies that may occur mainly at a part (e.g., the second portion ACT12 and the third portion ACT13) of the first active layer ACT1 overlaps the first gate electrode GE1 and the first gate insulating layer GI1 during the manufacturing process of the display panel 110, and may correspond to the section where the first source region SR1 and the first drain region DR1 extend.

Although FIG. 6 shows an embodiment in which the first channel region CH1 overlaps each of the first source region SR1 and the first drain region DR1 by the section corresponding to the same length, the embodiments are not limited thereto. Further, due to process variation or the like, the length and/or area of the section where the first channel region CH1 and the first source region SR1 overlap may be different from the length and/or area of the section where the first channel region CH1 and the first drain region DR1 overlap.

Accordingly, the first gate electrode GE1 may cover at least the first channel region CH1, and may overlap a part of the first source region SR1 and a part of the first drain region DR1 by the section corresponding to a first length (e.g., 2 times ΔL1, 2ΔL1), e.g., by the first length, in the longitudinal direction of the first active layer ACT1. For example, each of both ends of the first gate electrode GE1 may overlap the first source region SR1 and the first drain region DR1 by the area corresponding to the section of the length ΔL1 of the first active layer ACT1.

At least one first dummy gate electrode DG1 separated from and/or spaced apart from the first gate electrode GE1 may be disposed above at least one of the second portion ACT12 and the third portion ACT13 of the first active layer ACT1. In one embodiment, the first dummy gate electrodes DG1 may be disposed above each of the second portion ACT12 and the third portion ACT13 of the first active layer ACT1.

Since the plurality of first dummy gate electrodes DG1 (e.g., two first dummy gate electrodes DG1) spaced apart from the first gate electrode GE1 are disposed on both sides of the first gate electrode GE1, oxygen vacancies that mainly occur at a part of the first active layer ACT1 that is not covered with the first gate insulating layer GI1 may diffuse in both directions in the first active layer ACT1 during the manufacturing process of the display panel 110. For example, mainly at a part of the first active layer ACT1 exposed in the region between the first gate electrode GE1 and the first dummy gate electrodes DG1, oxygen vacancies may occur in the oxide semiconductor forming the first active layer ACT1 due to an etching gas or the like in the patterning process of the first gate insulating layer GI1 or the like. The oxygen vacancies may diffuse to the region under the first gate electrode GE1 of the first active layer ACT1, and may also diffuse to the region under each of the first dummy gate electrodes DG1 of the first active layer ACT1. For example, by forming the first dummy gate electrodes DG1, the diffusion direction of the oxygen vacancies occurring at the first active layer ACT1 may be distributed. In addition, since the first dummy gate electrodes DG1 spaced apart from the first gate electrode GE1 are disposed on both sides of the first gate electrode GE1, hydrogen flowing mainly into a part of the first active layer ACT1 that is not covered with the first gate insulating layer GI1 may diffuse in both directions in the first active layer ACT1 during the manufacturing process of the display panel 110.

Since the oxygen vacancies diffuse in both directions in the first active layer ACT1, it is possible to reduce the amount of diffusion of the oxygen vacancies diffused to a part of the first active layer ACT1 located under the first gate electrode GE1 and/or the length of the region where the oxygen vacancies diffuse under the first gate electrode GE1. Accordingly, the overlapping area between the first gate electrode GE1 and the first source and drain regions SR1 and DR1 may be reduced.

In the case that the overlapping area between the first gate electrode GE1 and the first source and drain regions SR1 and DR1 is reduced, the magnitude of the parasitic capacitance (e.g., the capacitance formed between the first gate electrode GE1 and the first source and drain regions SR1 and DR1) formed at the first transistor T1 may be reduced. In one embodiment, the first transistor T1 may be a driving transistor for controlling the driving current Id flowing toward the light emitting element ED in response to the voltage applied to the first gate electrode GE1. By reducing or minimizing the magnitude of the parasitic capacitance formed at the first transistor T1, it is possible to prevent, reduce, or minimize characteristic changes and/or characteristic variation of the first transistor T1. Accordingly, it is possible to prevent, reduce, or minimize blurring of the image due to the luminance variation of the pixels PX, and to improve the image quality of the display device 100.

In one embodiment, each of the first dummy gate electrodes DG1 may have a length Ld1 that is less than or equal to the first length corresponding to 2ΔL1 in the longitudinal direction of the first active layer ACT1. Accordingly, a part of the first active layer ACT1 that overlaps each of the first dummy gate electrodes DG1 may become conductive by hydrogen and/or oxygen vacancies flowing in from both directions. Accordingly, the second portion ACT12 and the third portion ACT13 of the first active layer ACT1, including the region overlapping each of the first dummy gate electrodes DG1, may be regions that have become conductive to the first source and drain regions SR1 and DR1. For example, the second portion ACT12 and the third portion ACT13 of the first active layer ACT1 may exhibit electrical characteristics that are substantially the same as those of a conductor.

The semiconductor layer SCL including the first active layer ACT1, the gate insulating layer GI including the first gate insulating layer GI1, and the second conductive layer CDL2 including the first gate electrode GE1 and the first dummy gate electrodes DG1 may be covered with the interlayer insulating layer ILD. A third conductive layer CDL3 may be disposed on the interlayer insulating layer ILD.

The first source electrode SE1 and the first drain electrode DE1 may be provided in the third conductive layer CDL3. For example, the third conductive layer CDL3 includes first source electrode SE1 and the first drain electrode DE1 and may optionally further include additional conductive patterns. The first source electrode SE1 and the first drain electrode DE1 may be disposed on the interlayer insulating layer ILD, and may be electrically connected to the first source region SR1 and the first drain region DR1, respectively.

In the embodiment of FIG. 6, the first transistor T1 of each pixel PX may be connected to the light emitting element ED of the corresponding pixel PX. For example, the first source electrode SE1 of each pixel PX may be directly connected to the first electrode ET1 of the light emitting element ED through at least one contact hole or via hole penetrating the passivation layer PSV.

However, the embodiments are not limited thereto. For example, the panel circuit layer PCL may further include the fourth conductive layer disposed on the passivation layer PSV and the insulating layer covering the fourth conductive layer, and the first transistor T1 may be connected to the light emitting element ED through a bridge pattern provided in the fourth conductive layer.

The second transistor T2 may include the second bottom gate electrode BG2 disposed on the substrate SUB, a second active layer ACT2 (also referred to as "second active pattern") disposed on the second bottom gate electrode BG2, and a second gate electrode GE2 disposed on the second active layer ACT2. The buffer layer BFL may be disposed between the second bottom gate electrode BG2 and the second active layer ACT2. The second gate insulating layer GI2 may be disposed between the second active layer ACT2 and the second gate electrode GE2.

In one embodiment, the second transistor T2 may further include the second source electrode SE2 and the second drain electrode DE2 connected to different parts of the second active layer ACT2. Alternatively, the second transistor T2 may not include a separate source electrode and/or a separate drain electrode, and a second drain region DR2 and/or a second source region SR2 of the second active layer ACT2 may be connected to another circuit element, wire, and/or conductive pattern to function as a source electrode and/or drain electrode of the second transistor T2.

The second bottom gate electrode BG2 may be provided in the first conductive layer CDL1 on the substrate SUB. For example, the second bottom gate electrode BG2 may be provided in the first conductive layer CDL1 together with the first bottom gate electrode BG1. In this case, the first conductive layer CDL1 may include the first bottom gate electrode BG1 and the second bottom gate electrode BG2.

The second bottom gate electrode BG2 may overlap the second active layer ACT2. For example, the second bottom gate electrode BG2 may be disposed under the second active layer ACT2 to overlap at least the second channel region CH2. The second bottom gate electrode BG2 and the second active layer ACT2 may be spaced apart from each other with the buffer layer BFL interposed therebetween. The second bottom gate electrode BG2 may face the second gate electrode GE2 with the second active layer ACT2 interposed therebetween. In one embodiment, the second bottom gate electrode BG2 may be connected to the second gate electrode GE2 of the second transistor T2 and may be utilized as a back-gate electrode to adjust the characteristics of the second transistor T2.

The second active layer ACT2 may be provided in the semiconductor layer SCL on the substrate SUB. In one embodiment, the first active layer ACT1 and the second active layer ACT2 may be provided and/or disposed on the same layer on the substrate SUB. For example, the semiconductor layer SCL may include the first active layer ACT1 and the second active layer ACT2.

The second active layer ACT2 may include a first portion ACT21 located at the center, and a second portion ACT22 and a third portion ACT23 spaced apart from each other with the first portion ACT21 disposed therebetween. For example, the second portion ACT22 and the third portion ACT23 of the second active layer ACT2 may be located on both sides of the first portion ACT21 of the second active layer ACT2.

At least a part of the second active layer ACT2 including the first portion ACT21 may overlap the second bottom gate electrode BG2. The first portion ACT21 of the second active layer ACT2 may include the second channel region CH2. In one embodiment, the entire first portion ACT21 of the second active layer ACT2 may be the second channel region CH2. The second channel region CH2 may be a region that maintains semiconductor characteristics without becoming conductive.

The second active layer ACT2 may include the second source region SR2 and the second drain region DR2 that are respectively located at the second portion ACT22 and the third portion ACT23. For example, the second portion ACT22 of the second active layer ACT2 may include the second source region SR2, and the third portion ACT23 of the second active layer ACT2 may include the second drain region DR2. In one embodiment, the entire second portion ACT22 of the second active layer ACT2 may be the second source region SR2, and the entire third portion ACT23 of the second active layer ACT2 may be the second drain region DR2. The second source region SR2 may be located on one side of the second channel region CH2, and the second drain region DR2 may be located on the other side of the second channel region CH2. The second source region SR2 and the second drain region DR2 may be spaced apart from each other with the second channel region CH2 interposed therebetween. The second source region SR2 and the second drain region DR2, which are regions that have become conductive, may have a carrier concentration (for example, electron concentration) higher than that of the second channel region CH2.

The second gate insulating layer GI2 may be disposed on a part of the second active layer ACT2. For example, the second gate insulating layer GI2 may be disposed between the second active layer ACT2 and the second gate electrode GE2, and between the second active layer ACT2 and second dummy gate electrodes DG2.

In one embodiment, the second gate insulating layer GI2 may have a shape that is etched to cover only a part of the second active layer ACT2 and expose the other part of the second active layer ACT2. For example, the second gate insulating layer GI2 may include an insulating pattern that is disposed between the second active layer ACT2 and the second gate electrode GE2 and covers at least the first portion ACT21 of the second active layer ACT2. For example, the second gate insulating layer GI2 may include an insulating pattern that is disposed under the second gate electrode GE2, and covers the first portion ACT21 of the second active layer ACT2 and a part of the second portion ACT22 and a part of the third portion ACT23 that are directly adjacent to the first portion ACT21. The second gate insulating layer GI2 may not be provided on another part of the second portion ACT22 and another part of the third portion ACT23 of the second active layer ACT2, and thus may expose another part of the second portion ACT22 and another part of the third portion ACT23 of the second active layer ACT2. The second gate insulating layer GI2 may include at least one insulating pattern disposed between the second active layer ACT2 and at least one second dummy gate electrode DG2 disposed on the second active layer ACT2. For example, the second gate insulating layer GI2 may further include insulating patterns respectively disposed under the second dummy gate electrodes DG2 located on both sides of the second gate electrode GE2. In one embodiment, the insulating patterns disposed on the second active layer ACT2 may be separated from each other, but the embodiments are not limited thereto.

Since the second gate insulating layer GI2 exposes a part of the second portion ACT22 and a part of the third portion ACT23 of the second active layer ACT2, the second source region SR2 and the second drain region DR2 may become appropriately and/or easily conductive during the manufacturing process of the display panel 110. For example, the second gate insulating layer GI2 is formed by etching the gate insulating layer GI such that a part of the second portion ACT22 and a part of the third portion ACT23 of the second active layer ACT2 are exposed, and the interlayer insulating layer ILD is formed in a state where a part of the second portion ACT22 and a part of the third portion ACT23 of the second active layer ACT2 are exposed, so that the second source region SR2 and the second drain region DR2 may become appropriately and/or easily conductive without performing a separate doping process.

The second gate electrode GE2 and the second dummy gate electrodes DG2 may be disposed on the second gate insulating layer GI2. The second gate electrode GE2 and the second dummy gate electrodes DG2 may be provided in the second conductive layer CDL2 on the substrate SUB. In this case, the second conductive layer CDL2 may include the first gate electrode GE1, the first dummy gate electrodes DG1, the second gate electrode GE2 and the second dummy gate electrodes DG2.

The second gate electrode GE2 may be disposed on a portion of the second active layer ACT2 including the first portion ACT21. For example, the second gate electrode GE2 may be disposed on the first portion ACT21 of the second active layer ACT2 to overlap at least the second channel region CH2.

In one embodiment, the second gate electrode GE2 may also be disposed on a part of the second portion ACT22 and a part of the third portion ACT23 of the second active layer ACT2 to overlap a part of the second source region SR2 and a part of the second drain region DR2. For example, the second gate electrode GE2 may overlap the second source region SR2 and the second drain region DR2 by a section corresponding to a length ΔL2 (e.g., by the length of ΔL2) in a part of the second source region SR2 and a part of the second drain region DR2 that are in contact with the second channel region CH2. The section corresponding to the length ΔL2 in each of the second source region SR2 and the second drain region DR2 may diffuse to a part of the region where oxygen vacancies that may occur mainly at a part (e.g., the second portion ACT22 and the third portion ACT23) of the second active layer ACT2 overlaps the second gate electrode GE2 and the second gate insulating layer GI2 during the manufacturing process of the display panel 110, and may correspond to the section where the second source region SR2 and the second drain region DR2 extend.

Although FIG. 6 shows an embodiment in which the second channel region CH2 overlaps each of the second source region SR2 and the second drain region DR2 by the section corresponding to the same length, the embodiments are not limited to thereto. Further, due to process variation or the like, the length and/or area of the section where the second channel region CH2 and the second source region SR2 overlap may be different from the length and/or area of the section where the second channel region CH2 and the second drain region DR2 overlap.

Accordingly, the second gate electrode GE2 may cover at least the second channel region CH2, and may overlap a part of the second source region SR2 and a part of the second drain region DR2 by the section corresponding to a second length (e.g., 2 times ΔL2, 2ΔL2), e.g., by the second length, in the longitudinal direction of the second active layer ACT2. For example, each of both ends of the second gate electrode GE2 may overlap the second source region SR2 and the second drain region DR2 by the area corresponding to the section of the length ΔL2 of the second active layer ACT2. In one embodiment, the first length and the second length (or ΔL1 and ΔL2) may be substantially the same, but the embodiments are not limited thereto.

At least one second dummy gate electrode DG2 separated from and/or spaced apart from the second gate electrode GE2 may be disposed above at least one of the second portion ACT22 and the third portion ACT23 of the second active layer ACT2. In one embodiment, the second dummy gate electrodes DG2 may be disposed above each of the second portion ACT22 and the third portion ACT23 of the second active layer ACT2.

Since the plurality of second dummy gate electrodes DG2 (e.g., two second dummy gate electrodes DG2) spaced apart from the second gate electrode GE2 are disposed on both sides of the second gate electrode GE2, oxygen vacancies that mainly occurs on a part of the second active layer ACT2 that is not covered with the second gate insulating layer GI2 may diffuse in both directions in the second active layer ACT2 during the manufacturing process of the display panel 110. For example, oxygen vacancies may occur in the oxide semiconductor forming the second active layer ACT2 in the patterning process of the second gate insulating layer GI2. The oxygen vacancies may diffuse to the region under the second gate electrode GE2 of the second active layer ACT2, and may also diffuse to the region under each of the second dummy gate electrodes DG2 of the second active layer ACT2. For example, by forming the second dummy gate electrodes DG2, the diffusion direction of the oxygen vacancies occurring at the second active layer ACT2 may be distributed. In addition, since the second dummy gate electrodes DG2 spaced apart from the second gate electrode GE2 are disposed on both sides of the second gate electrode GE2, hydrogen flowing mainly into a part of the second active layer ACT2 that is not covered with the second gate insulating layer GI2 may diffuse in both directions in the second active layer ACT2 during the manufacturing process of the display panel 110.

Since the oxygen vacancies diffuse in both directions in the second active layer ACT2, it is possible to reduce the amount of diffusion of the oxygen vacancies diffused to a part of the second active layer ACT2 located under the second gate electrode GE2 and/or the length of the region where the oxygen vacancies diffuse under the second gate electrode GE2. Accordingly, the overlapping area between the second gate electrode GE2 and the second source and drain regions SR2 and DR2 may be reduced.

In the case that the overlapping area between the second gate electrode GE2 and the second source and drain regions SR2 and DR2 is reduced, the magnitude of the parasitic capacitance (e.g., the capacitance formed between the second gate electrode GE2 and the second source and drain regions SR2 and DR2) formed at the second transistor T2 may be reduced. In one embodiment, the second transistor T2 may be electrically connected to the first gate electrode GE1. For example, the second source region SR2 and/or the second source electrode SE2 of the second transistor T2 may be electrically connected to the first gate electrode GE1. By reducing or minimizing the magnitude of the parasitic capacitance formed at the second transistor T2, the voltage variation of the first node N1 connected to the first gate electrode GE1 may be prevented, reduced, or minimized. Accordingly, it is possible to prevent, reduce, or minimize blurring of the image due to the luminance variation of the pixels PX, and to improve the image quality of the display device 100. In one embodiment, the second transistor T2 may be a switching transistor connected to the first driver 120 through a gate line GL (e.g., the first gate line GWL). By reducing or minimizing the magnitude of the parasitic capacitance formed at the second transistor T2, the load formed at the output terminal of the first driver 120 may be reduced. Accordingly, the output characteristics of the first driver 120 may be improved. In one embodiment, at least one dummy gate electrode may also be disposed in at least one other pixel transistor Tpx connected to the first node N1, similarly to the third transistor T3. Accordingly, it is possible to prevent, reduce, or minimize the voltage variation of the first node N1, and to reduce the load formed at the output terminal of the first driver 120.

In one embodiment, each of the second dummy gate electrodes DG2 may have a length Ld2 that is less than or equal to the second length corresponding to 2ΔL2 in the longitudinal direction of the second active layer ACT2. Accordingly, a part of the second active layer ACT2 that overlaps each of the second dummy gate electrodes DG2 may become electrically conductive by hydrogen and/or oxygen vacancies flowing in from both directions. Accordingly, the second portion ACT22 and the third portion ACT23 of the second active layer ACT2, including the region overlapping each of the second dummy gate electrodes DG2, may be regions that have become conductive to the second source and drain regions SR2 and DR2. For example, the second portion ACT22 and the third portion ACT23 of the second active layer ACT2 may exhibit electrical characteristics that are substantially the same as those of a conductor.

The second source electrode SE2 and the second drain electrode DE2 may be provided in the third conductive layer CDL3. In this case, the third conductive layer CDL3 may include the first source electrode SE1, the first drain electrode DE1, second source electrode SE2 and the second drain electrode DE2. For example, the second source electrode SE2 and the second drain electrode DE2 may be disposed on the interlayer insulating layer ILD, and may be electrically connected to the second source region SR2 and the second drain region DR2, respectively.

The pixel transistors Tpx, including the first transistor T1 and the second transistor T2 may be covered by the passivation layer PSV.

The respective electrodes, conductive patterns, and/or wires provided in the conductive layers (e.g., included in the conductive layers) of the panel circuit layer PCL may include at least one conductive material, and may each have a single layer structure or a multilayer structure. For example, the electrodes, the conductive patterns, and/or the wires provided in each of the first conductive layer CDL1, the second conductive layer CDL2, and the third conductive layer CDL3 may include at least one of copper (Cu), titanium (Ti), molybdenum (Mo), aluminium (Al), chromium (Cr), gold (Au), silver (Ag), platinum (Pt), palladium (Pd), nickel (Ni), neodymium (Nd), iridium (Ir), tantalum (Ta), tungsten (W), magnesium (Mg), or another metal, an alloy thereof, or another conductive material, and may each have a single layer structure or a multilayer structure. In one embodiment, the electrodes, the conductive patterns, and/or the wires disposed on the same conductive layer may be simultaneously formed using the same conductive material.

In one embodiment, the active layers, e.g., the first active layer ACT1 and the second active layer ACT2, provided in the semiconductor layer SCL (e.g., included in the semiconductor layer SCL) may include an oxide semiconductor. For example, the active layers provided in the semiconductor layer SCL may include at least one of indium (In), gallium (Ga), zinc (Zn), or tin (Sn). For example, each of the first active layer ACT1 and the second active layer ACT2 may include at least one of zinc oxide (ZnO), zinc-tin oxide (ZTO), indium-zinc oxide (IZO), indium oxide (InO), titanium oxide (TiO), indium-gallium oxide (IGO), indium-gallium-zinc oxide (IGZO), indium-gallium-tin oxide (IGTO), indium-zinc-tin oxide (IZTO), or indium-tin-gallium- zinc oxide (ITGZO), or another oxide semiconductor. The oxide semiconductor used to form the oxide transistors including the first transistor T1 and the second transistor T2 is not limited to the above-exemplified materials, and may be variously changed according to embodiments.

In one embodiment, the active layers provided in the same semiconductor layer SCL may include the same oxide semiconductor. For example, the first active layer ACT1 and the second active layer ACT2 may be formed simultaneously using the same oxide semiconductor.

The light emitting element layer LEL may be disposed on the panel circuit layer PCL, and may be located in the display area DA. For example, the light emitting element layer LEL may be disposed on the panel circuit layer PCL in the display area DA.

The light emitting element layer LEL may include the light emitting elements ED of the pixels PX. For example, the light emitting element layer LEL may include a pixel defining layer PDL (also referred to as "bank") that partitions the emission areas of the pixels PX and the light emitting element ED located in each emission area. In one embodiment, the light emitting element layer LEL may further include a spacer SPC disposed on a part of the pixel defining layer PDL.

Each light emitting element ED may include the first electrode ET1 connected to at least one pixel transistor Tpx (for example, the first transistor T1) included in the corresponding pixel PX, and a light emitting layer EML and a second electrode ET2 that are sequentially disposed on the first electrode ET1. In one embodiment, the light emitting element ED may further include a first intermediate layer (e.g., hole layer including a hole transport layer) interposed between the first electrode ET1 and the light emitting layer EML, and a second intermediate layer (e.g., an electron layer including an electron transport layer) interposed between the light emitting layer EML and the second electrode ET2.

The first electrode ET1 of the light emitting element ED may be disposed on the panel circuit layer PCL to correspond to each emission area. The first electrode ET1 may include a conductive material. In one embodiment, the first electrode ET1 may include a metallic material having high reflectivity. For example, the first electrode ET1 may have a single layer structure of molybdenum (Mo), titanium (Ti), copper (Cu) or aluminium (Al), or may have a multi-layer structure (e.g., ITO/Mg, ITO/MgF, ITO/Ag, and ITO/Ag/ITO) including indium-tin-oxide (ITO), indium-zinc-oxide (IZO), zinc oxide (ZnO), indium oxide (In₂O₃) and silver (Ag), magnesium (Mg), aluminium (Al), platinum (Pt), lead (Pb), gold (Au), or nickel (Ni).

The light emitting layer EML of the light emitting element ED may include a polymer material or a low molecular material. Light emitted from the light emitting layer EML may contribute to image display. In one embodiment, the light emitting layer EML may be provided for each pixel PX, and the light emitting layer EML of each pixel PX may emit visible light of a color corresponding to the corresponding pixel PX. In another embodiment, the light emitting layer EML may be a common layer shared by the pixels PX of different colors, and a wavelength conversion layer and/or color filters corresponding to the color (or wavelength band) of light desired to be emitted from each pixel PX may be arranged in the emission areas of at least some of the pixels PX.

The second electrode ET2 of the light emitting element ED may include a conductive material. In one embodiment, the second electrode ET2 may be a common layer formed across the entire display area DA to cover the light emitting layer EML and the pixel defining layer PDL. In one embodiment, the second electrode ET2 may be formed of a transparent conductive material (TCO) such as ITO, IZO, ZnO, or ITZO capable of transmitting light or a semi-transmissive conductive material such as magnesium (Mg), silver (Ag), or an alloy of magnesium (Mg) and silver (Ag).

The pixel defining layer PDL may have an opening corresponding to each emission area and may surround the emission area. For example, the pixel defining layer PDL may be formed to cover an edge of the first electrode ET1 of the light emitting element ED and may include an opening exposing the remaining portion of the first electrode ET1. A region where the exposed first electrode ET1 and the light emitting layer EML overlap may be defined as the emission area of each pixel PX.

In one embodiment, the pixel defining layer PDL may include at least one organic insulating layer containing an organic insulating material. For example, the pixel defining layer PDL may include acrylic resin, epoxy resin, phenolic resin, polyamide resin, polyimide resin, unsaturated polyester resin, polyphenylene ether resin, polyphenylenesulfide resin and benzocyclobutene (BCB) or other organic insulating materials.

The spacer SPC may be disposed on a part of the pixel defining layer PDL. The spacer SPC may include at least one organic insulating layer containing an organic insulating material. The spacer SPC may include the same material as the pixel defining layer PDL or may include a different material from the pixel defining layer PDL. In one embodiment, the pixel defining layer PDL and the spacer SPC may be sequentially formed through separate mask processes. In another embodiment, the pixel defining layer PDL and the spacer SPC may be an integrated pattern formed simultaneously using a halftone mask.

The encapsulation layer ENL may be disposed on the light emitting element layer LEL. The encapsulation layer ENL may cover the light emitting element layer LEL in the display area DA and may extend to the non-display area NDA to be in contact with the panel circuit layer PCL. For example, the encapsulation layer ENL may be disposed in the display area DA to cover the light emitting element layer LEL, and the end of the encapsulation layer ENL may be located in a portion of the non-display area NDA adjacent to the display area DA. The encapsulation layer ENL may block the permeation of oxygen or moisture into the light emitting element layer LEL, and may reduce electrical and/or physical impacts to the panel circuit layer PCL and the light emitting element layer LEL.

In one embodiment, the encapsulation layer ENL may have a multilayer structure including a first encapsulation layer ENL1, a second encapsulation layer ENL2, and a third encapsulation layer ENL3 sequentially disposed on the light emitting element layer LEL. Each of the first encapsulation layer ENL1 and the third encapsulation layer ENL3 may be an inorganic encapsulation layer containing an inorganic material. The second encapsulation layer ENL2 may be an organic encapsulation layer containing an organic material. The structure and/or material of the encapsulation layer ENL may be changed according to embodiments.

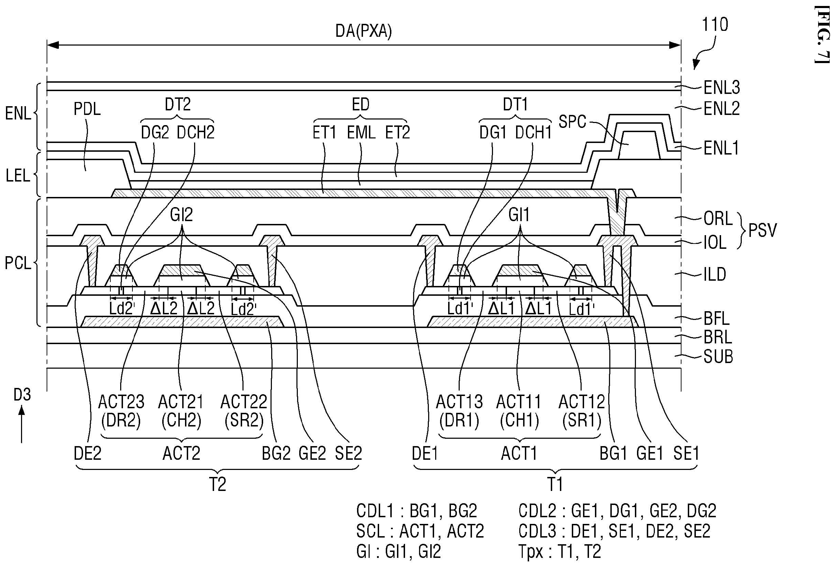

FIG. 7 is a cross-sectional view illustrating the display panel 110 according to one embodiment. For example, FIG. 7 shows an embodiment that is different from the embodiment of FIG. 6 in relation to the lengths of the first and second dummy gate electrodes DG1 and DG2. In describing the following embodiments, redundant descriptions of components substantially identical or similar to those of at least one embodiment described above will be omitted.

Referring to FIG. 7 in addition to FIGS. 1 to 6, at least one first dummy gate electrode DG1 may have a length Ld1' longer than the first length (e.g., 2ΔL1) in the longitudinal direction of the first active layer ACT1. Accordingly, the first active layer ACT1 may include at least one first dummy channel region DCH1 that is located in at least one of the second portion ACT12 or the third portion ACT13 and overlaps at least one first dummy gate electrode DG1.

For example, each of the first dummy gate electrodes DG1 located on both sides of the first gate electrode GE1 may have the length Ld1' longer than the first length (e.g., 2ΔL1) in the longitudinal direction of the first active layer ACT1. Accordingly, the first dummy channel region DCH1 may be formed under each of the first dummy gate electrodes DG1. For example, the first dummy channel region DCH1 may have a length corresponding to the value obtained by subtracting the first length (e.g., 2ΔL1) from the length Ld1' of each of the first dummy gate electrodes DG1.

In embodiments, the second portion ACT12 and the third portion ACT13 of the first active layer ACT1 may refer to portions located on different sides of the first portion ACT11. For example, the second portion ACT12 of the first active layer ACT1 may include at least the first source region SR1. Further, when the first dummy channel region DCH1 is formed under the first dummy gate electrode DG1 disposed on the second portion ACT12 of the first active layer ACT1, the second portion ACT12 of the first active layer ACT1 may include the first dummy channel region DCH1 and the regions (e.g., the first source region SR1 of the first transistor T1, or the source and drain regions of the first dummy transistor DT1) that have become conductive on both sides of the first dummy channel region DCH1. Similarly, the third portion ACT13 of the first active layer ACT1 may include at least the first drain region DR1. Further, when the first dummy channel region DCH1 is formed under the first dummy gate electrode DG1 disposed on the third portion ACT13 of the first active layer ACT1, the third portion ACT13 of the first active layer ACT1 may include the first dummy channel region DCH1 and the regions (e.g., the first drain region DR1 of the first transistor T1, or the source and drain regions of the first dummy transistor DT1) that have become conductive on both sides of the first dummy channel region DCH1.

Each first dummy gate electrode DG1 may cover each first dummy channel region DCH1, and may overlap a part of the first source region SR1 or a part of the first drain region DR1 around the first dummy channel region DCH1. For example, the first dummy gate electrode DG1 disposed on the second portion ACT12 of the first active layer ACT1 may cover the first dummy channel region DCH1 located at the second portion ACT12 of the first active layer ACT1, and may overlap a part of the first source region SR1 adjacent to the first dummy channel region DCH1. The first dummy gate electrode DG1 disposed on the third portion ACT13 of the first active layer ACT1 may cover the first dummy channel region DCH1 located at the third portion ACT13 of the first active layer ACT1, and may overlap a part of the first drain region DR1 adjacent to the first dummy channel region DCH1.

In one embodiment, each first dummy channel region DCH1 may have a short channel whose length falls within a threshold voltage roll-off section of the first dummy transistor DT1 including the first dummy channel region DCH1 and each first dummy gate electrode DG1. For example, each first dummy channel region DCH1 may have a short channel, and accordingly, the first dummy transistor DT1 may operate in a threshold voltage roll-off region. For example, the length Ld1' of each of the first dummy gate electrodes DG1 may be smaller than or equal to the sum of a sub-threshold channel length of the first dummy transistor DT1 and the first length (e.g., 2ΔL1). Accordingly, each first dummy channel region DCH1 may have a length smaller than or equal to the sub-threshold voltage channel length of the first dummy transistor DT1. In one embodiment, each first dummy gate electrode DG1 may have a length smaller than that of the gate electrode GE of each of the pixel transistors Tpx provided in each pixel PX. Accordingly, each first dummy channel region DCH1 may have a length smaller than the length of the channel region of each of the pixel transistors Tpx.

Each first dummy transistor DT1 may substantially operate as a conductor due to a short-channel effect. For example, each first dummy transistor DT1 may operate as a wire.

Similarly, at least one second dummy gate electrode DG2 may have a length Ld2' longer than the second length (e.g., 2ΔL2) in the longitudinal direction of the second active layer ACT2. Accordingly, the second active layer ACT2 may include at least one second dummy channel region DCH2 that is located in at least one of the second portion ACT22 or the third portion ACT23 and overlaps at least one second dummy gate electrode DG2.

For example, each of the second dummy gate electrodes DG2 located on both sides of the second gate electrode GE2 may have the length Ld2' longer than the second length (e.g., 2ΔL2) in the longitudinal direction of the second active layer ACT2. Accordingly, the second dummy channel region DCH1 may be formed under each of the second dummy gate electrodes DG2. For example, the second dummy channel region DCH2 may have a length corresponding to the value obtained by subtracting the second length (e.g., 2ΔL2) from the length Ld2' of each of the second dummy gate electrodes DG2.

Each second dummy gate electrode DG2 may cover each second dummy channel region DCH2, and may overlap a part of the second source region SR2 or a part of the second drain region DR2 around the second dummy channel region DCH2. For example, the second dummy gate electrode DG2 disposed on the second portion ACT22 of the second active layer ACT2 may cover the second dummy channel region DCH2 located at the second portion ACT22 of the second active layer ACT2, and may overlap a part of the second source region SR2 adjacent to the second dummy channel region DCH2. The second dummy gate electrode DG2 disposed on the third portion ACT23 of the second active layer ACT2 may cover the second dummy channel region DCH2 located at the third portion ACT23 of the second active layer ACT2, and may overlap a part of the second drain region DR2 adjacent to the second dummy channel region DCH2.

In one embodiment, each second dummy channel region DCH2 may have a short channel whose length falls within a threshold voltage roll-off section of the second dummy transistor DT2 including the second dummy channel region DCH2 and each second dummy gate electrode DG2. For example, each second dummy channel region DCH2 may have a short channel, and accordingly, the second dummy transistor DT2 may operate in a threshold voltage roll-off region. For example, the length Ld2' of each of the second dummy gate electrodes DG2 may be less than or equal to the sum of the sub-threshold voltage channel length of the second dummy transistor DT2 and the second length (e.g., 2ΔL2). Accordingly, each second dummy channel region DCH2 may have a length less than or equal to the sub-threshold voltage channel length of the second dummy transistor DT2. In one embodiment, each second dummy gate electrode DG2 may have a length smaller than that of the gate electrode GE of each of the pixel transistors Tpx provided in each pixel PX. Accordingly, each second dummy channel region DCH2 may have a length smaller than that of the length of the channel region of each of the pixel transistors Tpx provided in each pixel PX.

Each second dummy transistor DT2 may substantially operate as a conductor due to the short channel effect. For example, each second dummy transistor DT2 may operate as a wire.

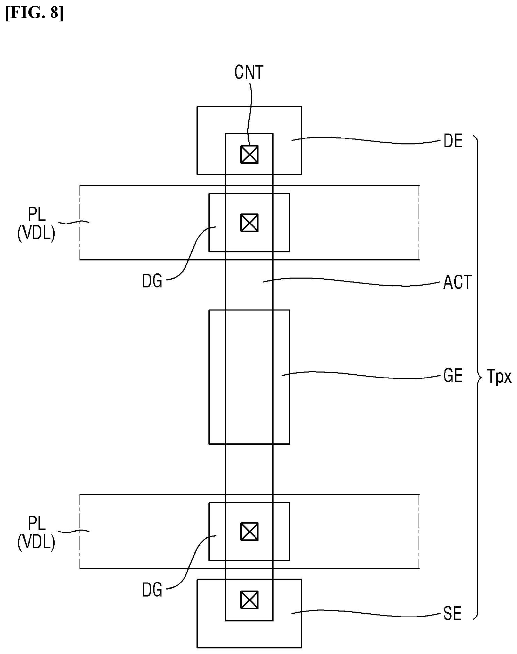

FIG. 8 is a plan view showing the pixel transistor Tpx and the dummy gate electrode DG according to one embodiment. For example, FIG. 8 shows an additional embodiment of the embodiment of FIG. 5 in relation to the dummy gate electrode DG.

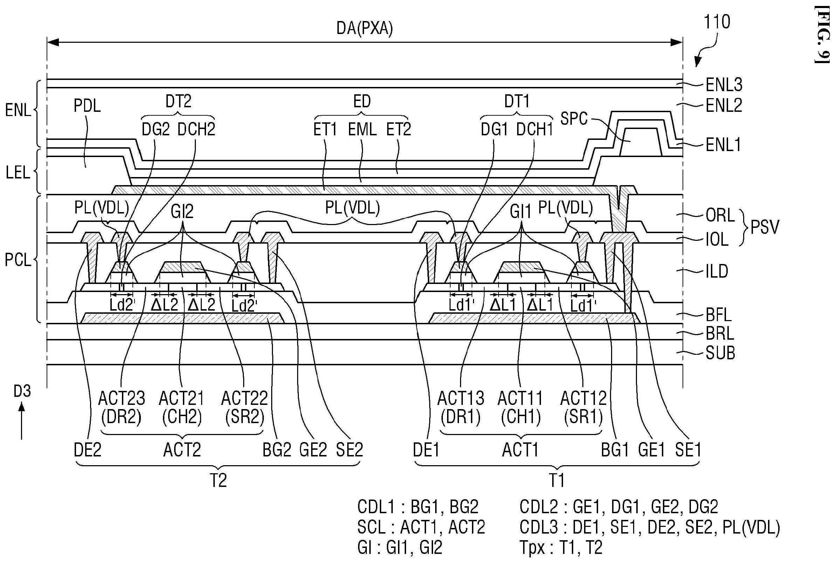

FIG. 9 is a cross-sectional view illustrating the display panel 110 according to one embodiment. For example, FIG. 9 shows an additional embodiment of the embodiments of FIGS. 6 and 7 in relation to the first and second dummy gate electrodes DG1 and DG2.

Referring to FIGS. 8 and 9 in addition to FIGS. 1 to 7, the display panel 110 may include a power line PL connected to each dummy gate electrode DG and to which the gate-on voltage of each pixel transistor Tpx is applied. In one embodiment, the power line PL may be provided in the third conductive layer CDL3, but the present disclosure is not limited thereto. The location, shape, and/or cross-sectional structure of the power line PL may be variously changed depending on embodiments.

In one embodiment, the power line PL may be the first power line VDL to which the first pixel voltage ELVDD is applied, and the plurality of dummy gate electrodes DG formed in the pixel PX may be connected to the same first power line VDL. For example, the plurality of dummy gate electrodes DG formed in the pixel PX, including the first dummy gate electrodes DG1 and the second dummy gate electrodes DG2, may be commonly connected to the first power line VDL (or sub-wires constituting the first power line VDL). However, the embodiments are not limited thereto. For example, the power line PL connected to each dummy gate electrode DG may be variously changed depending on embodiments.

Since each dummy gate electrode DG is connected to the power line PL, the gate-on voltage may be applied to each dummy gate electrode DG. Accordingly, the dummy transistors (e.g., the plurality of dummy transistors including the first dummy transistors DT1 and the second dummy transistors DT2) formed in the pixel PX may maintain a turn-on state for a period in which the display panel 110 is driven.

For example, even if each first dummy gate electrode DG1 has the length Ld1' longer than the first length corresponding to 2ΔL1, the gate-on voltage may be applied to each first dummy gate electrode DG1 during the period in which the display device 100 is driven and, accordingly, each first dummy transistor DT1 may maintain a turned-on state. For example, each first dummy transistor DT1 may operate as a wire.

Similarly, even if each second dummy gate electrode DG2 has the length Ld2' longer than the second length corresponding to 2ΔL2, the gate-on voltage may be applied to each second dummy gate electrode DG2 during the period in which the display device 100 is driven. Accordingly, each second dummy transistor DT2 may operate as a wire while maintaining the turn-on state.

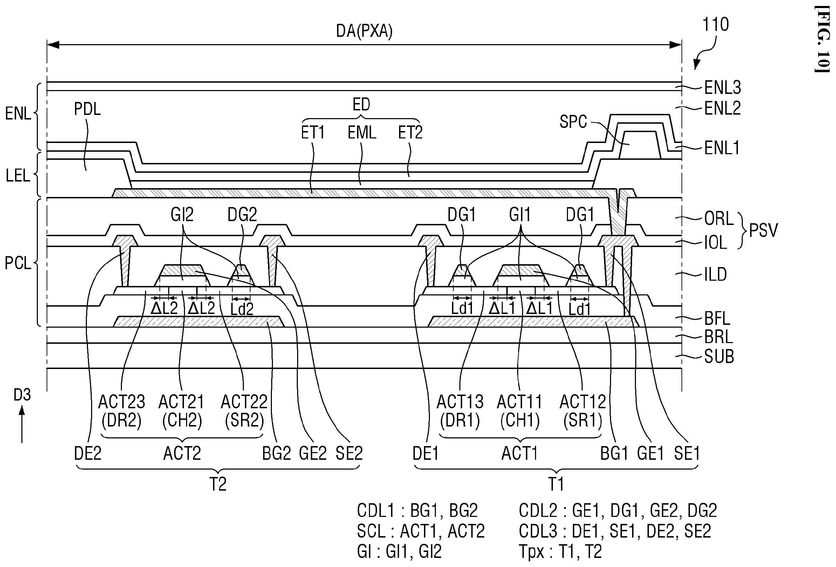

FIG. 10 is a cross-sectional view illustrating the display panel 110 according to one embodiment. For example, FIG. 10 shows an embodiment that is different from the embodiments of FIGS. 6 to 9 in relation to the second dummy gate electrode DG2. For example, FIG. 10 shows a modified embodiment of the embodiment of FIG. 6 in relation to the second dummy gate electrode DG2.

Referring to FIG. 10 in addition to FIGS. 1 to 9, the second dummy gate electrode DG2 may be disposed on (or disposed at) only one side of the second gate electrode GE2. For example, the pixel PX may include a single second dummy gate electrode DG2 disposed only on the second portion ACT22 of the second active layer ACT2, and the second dummy gate electrode DG2 may not be disposed on the third portion ACT23 of the second active layer ACT2. The second portion ACT22 of the second active layer ACT2 may be a portion including the second source region SR2 electrically connected to the first gate electrode GE1.

Since the second dummy gate electrode DG2 is disposed on the second portion ACT22 of the second active layer ACT2, the magnitude of the parasitic capacitance formed between the second source region SR2 and the second gate electrode DG2 may be reduced. Accordingly, the image quality of the display device 100 may be improved by preventing, reducing, or minimizing voltage variation of the first node N1 connected to the first gate electrode GE1.

Since the second dummy gate electrode DG2 is not disposed on the third portion ACT23 of the second active layer ACT2, the size of the second transistor T2 (e.g., the length of the second active layer ACT2) may be reduced. Accordingly, the pixel area PXA may be utilized more efficiently.

In one embodiment, a single dummy gate electrode may be formed only at the portion connected to the first node N1 in at least one other pixel transistor Tpx connected to the first node N1, similarly to the third transistor T3. Accordingly, the area occupied by the pixel transistors Tpx may be reduced while preventing, reducing, or minimizing voltage variation of the first node N1.

Although FIGS. 6 to 10 show the embodiments in which at least one dummy gate electrode DG is disposed on the active layer ACT of each of the first transistor T1 that is the driving transistor of the pixel PX, and at least one switching transistor (e.g., the second transistor T2), the embodiments are not limited thereto. In another embodiment, at least one first dummy gate electrode DG1 (e.g., two second dummy gate electrodes DG2 located on both sides of the first gate electrode GE1) may be provided only on the first active layer ACT1 of the first transistor T1, and the dummy gate electrode DG may not be disposed on the active layers ACT of the other pixel transistors Tpx (e.g., switching transistors). For example, the dummy gate electrode DG may be selectively disposed only in some pixel transistors Tpx in consideration of the operating characteristics of the pixel transistors Tpx and the area of the pixel area PXA. Alternatively, at least one dummy gate electrode DG may be disposed in each of all the pixel transistors Tpx to reduce changes and/or variation of the operating characteristics due to a parasitic capacitance. For example, the dummy gate electrode DG may be selectively formed in each pixel transistor Tpx in consideration of the area of the pixel area PXA and the operating characteristics of the pixel PX to be secured.

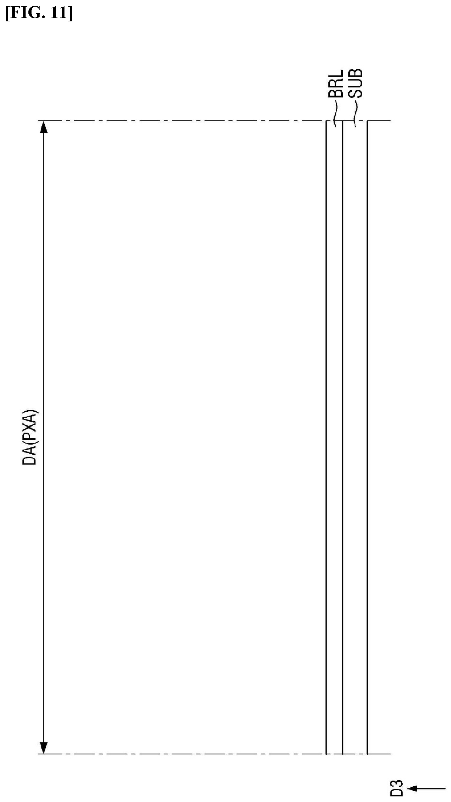

FIGS. 11 to 18 are cross-sectional views illustrating a method for manufacturing the display device 100 according to one embodiment. For example, FIGS. 11 to 18 sequentially show steps of forming the pixel transistors Tpx on the substrate SUB among the steps of manufacturing the display panel 110 of FIG. 6. In one embodiment, the driver transistors provided in the first driver 120 may be formed simultaneously with the pixel transistors Tpx in a substantially same or similar manner as the pixel transistors Tpx.

Referring to FIG. 11 in addition to FIGS. 1 to 10, the substrate SUB including at least the display area DA may be prepared. The display area DA may include the pixel area PXA.

In one embodiment, the barrier layer BRL may be formed on the substrate SUB. The barrier layer BRL may be formed through a film forming process (e.g., deposition process) of an insulating layer using at least one insulating material (e.g., an inorganic insulating material) exemplified above. Materials and/or methods for forming the barrier layer BRL may be variously changed according to embodiments.

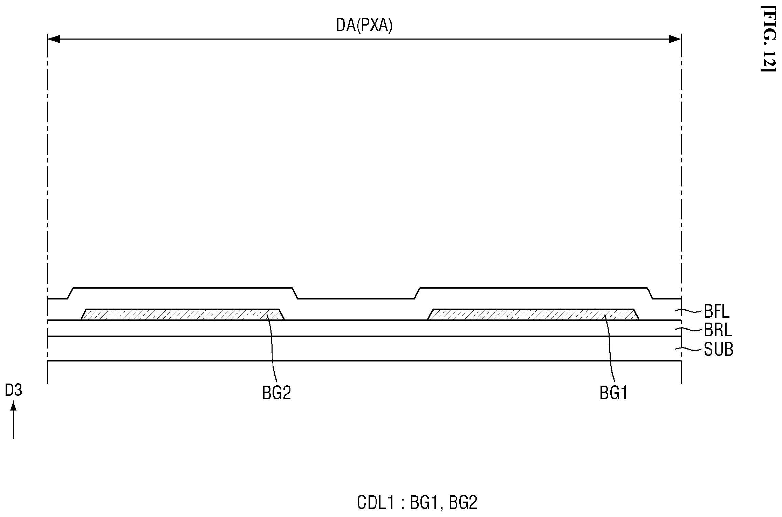

Referring to FIG. 12 in addition to FIGS. 1 to 11, the first conductive layer CDL1 including the bottom gate electrodes BG of the pixel transistors Tpx may be formed on the substrate SUB. For example, the first conductive layer CDL1 including the first bottom gate electrode BG1 and the second bottom gate electrode BG2 may be formed on the barrier layer BRL on the substrate SUB. The first bottom gate electrode BG1 and the second bottom gate electrode BG2 may be formed in each of the pixel areas PXA.

The first bottom gate electrode BG1 and the second bottom gate electrode BG2 may be formed by a film forming process (for example, a deposition process) of a conductive layer using at least one conductive material exemplified above and a patterning process (for example, an etching process using a mask) of the conductive layer. Materials and/or methods for forming the first bottom gate electrode BG1 and the second bottom gate electrode BG2 may be variously changed according to embodiments.

Thereafter, the buffer layer BFL covering the first conductive layer CDL1 may be formed on the substrate SUB. The buffer layer BFL may be formed through a film forming process of an insulating layer using at least one insulating material (e.g., an inorganic insulating material) exemplified above. Materials and/or methods for forming the buffer layer BFL may be variously changed according to embodiments.

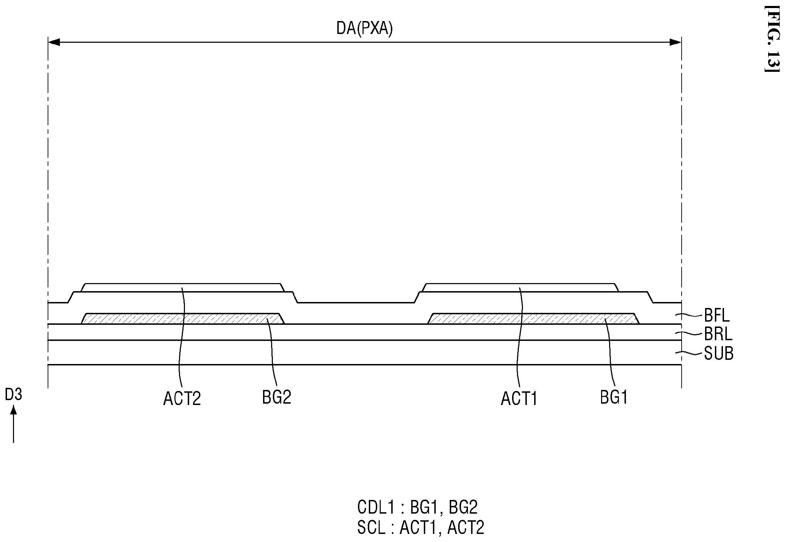

Referring to FIG. 13 in addition to FIGS. 1 to 12, the semiconductor layer SCL including the active layers ACT of the pixel transistors Tpx may be formed on the buffer layer BFL. For example, the first active layer ACT1, the second active layer ACT2 and the like may be formed in each of the pixel areas PXA. The first active layer ACT1 may be formed to overlap at least a part of the first bottom gate electrode BG1, and the second active layer ACT2 may be formed to overlap at least a part of the second bottom gate electrode BG2.

In one embodiment, the active layers ACT provided in the same semiconductor layer SCL may be formed simultaneously using the same oxide semiconductor. For example, the first active layer ACT1 and the second active layer ACT2 may be formed simultaneously using the same oxide semiconductor. For example, the first active layer ACT1, the second active layer ACT2 and the like may be formed in the pixel area PXA through the film forming process and patterning process of the oxide semiconductor layer using at least one oxide semiconductor exemplified above.

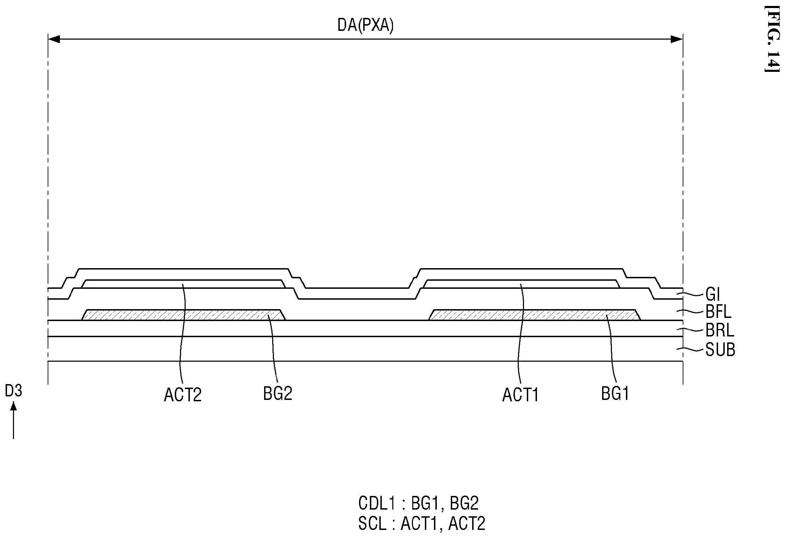

Referring to FIG. 14 in addition to FIGS. 1 to 13, the gate insulating layer GI covering the semiconductor layer SCL may be formed on the substrate SUB. For example, the gate insulating layer GI covering the active layers (e.g., the first active layer ACT1 and the second active layer ACT2) provided in the semiconductor layer SCL may be formed on the substrate SUB.

The gate insulating layer GI may first be formed entirely on the substrate SUB provided with the first and second active layers ACT1 and ACT2. For example, after the gate insulating layer GI is formed on the substrate SUB on which the semiconductor layer SCL is formed by a film forming process of an insulating layer using at least one insulating material (e.g., an inorganic insulating material) exemplified above, a subsequent process such as heat treatment (e.g., annealing) or the like may be performed. Materials and/or methods for forming the gate insulating layer GI may be variously changed according to embodiments.

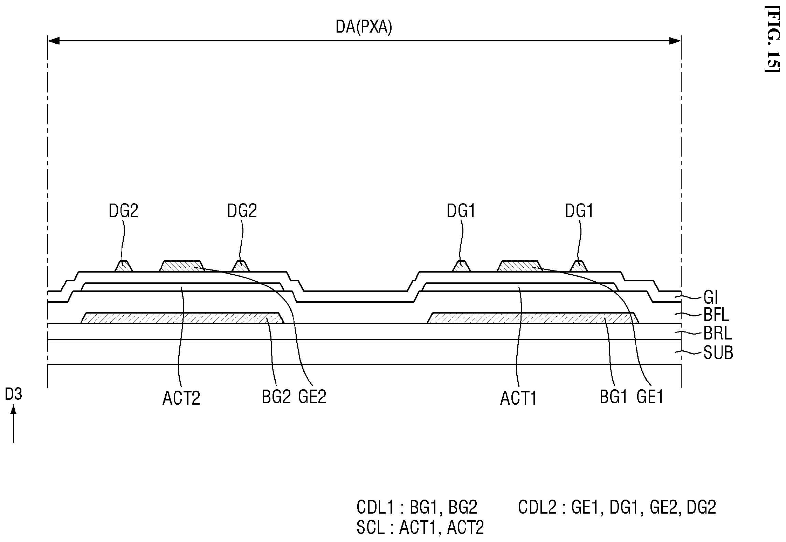

Referring to FIG. 15 in addition to FIGS. 1 to 14, the second conductive layer CDL2 may be formed on the gate insulating layer GI. The second conductive layer CDL2 may include the gate electrodes GE of the pixel transistors Tpx, including the first gate electrode GE1 and the second gate electrode GE2, and the dummy gate electrode DG disposed on the active layer ACT of at least one pixel transistor Tpx. On the active layer ACT where the dummy gate electrode DG is disposed, the gate electrode GE and at least one dummy gate electrode DG may be formed separately from each other while overlapping different parts of the active layer ACT. For example, the gate electrodes GE including the first gate electrode GE1 and the second gate electrode GE2, at least one first dummy gate electrode DG1 disposed on the first active layer ACT1 and separated from the first gate electrode GE1, and at least one second dummy gate electrode DG2 disposed on the second active layer ACT2 and separated from the second gate electrode GE2 may be formed in each pixel area PXA.

The gate electrodes GE and the dummy gate electrodes DG may be formed by a film forming process (e.g., a deposition process) of a conductive layer using at least one conductive material exemplified above and a patterning process (e.g., an etching process using a mask) of the conductive layer. Materials and/or methods for forming the gate electrodes GE and the dummy gate electrodes DG may be variously changed depending on embodiments.

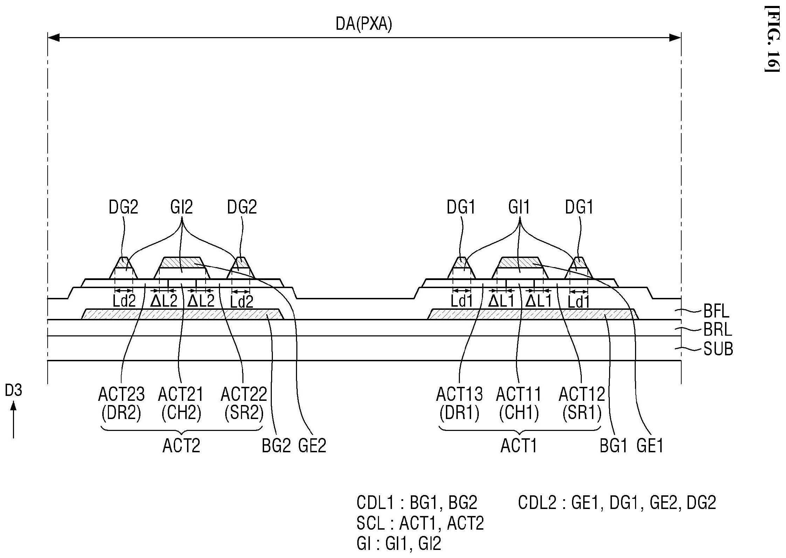

Referring to FIG. 16 in addition to FIGS. 1 to 15, the gate insulating layer GI may be etched to form the first gate insulating layer GI1 and the second gate insulating layer GI2. For example, by etching the gate insulating layer GI, the insulating patterns may be formed under the gate electrodes GE including the first and second gate electrodes GE1 and GE2 and the dummy gate electrodes DG including the first and second dummy gate electrodes DG1 and DG2, and a part of each of the active layers ACT may be exposed in the region that does not overlap the gate electrodes GE and the dummy gate electrodes DG.

In one embodiment, the gate insulating layer GI may be etched while utilizing a mask used for patterning the gate electrodes GE and the dummy gate electrodes DG or utilizing the gate electrodes GE and the dummy gate electrodes DG as a mask. Accordingly, the insulating patterns corresponding to the shapes and sizes of the gate electrodes GE and the dummy gate electrodes DG may be formed under the gate electrodes GE and the dummy gate electrodes DG.

In the process of forming the first gate insulating layer GI1 and the second gate insulating layer GI2 by etching the gate insulating layer GI, the properties of the active layers ACT may be changed such that the active layers ACT have different characteristics at different parts. Accordingly, the active layers ACT may be divided into a plurality of regions (e.g., a channel region, a source region, and a drain region) having different characteristics.

For example, mainly at a part that does not overlap the first gate electrode GE1 and the first dummy gate electrodes DG1, oxygen may be released from the oxide semiconductor constituting the first semiconductor pattern ACT1 by an etching gas or the like, and oxygen vacancies may occur. Accordingly, the first active layer ACT1 may be divided into a plurality of regions (e.g., the first channel region CH1, the first drain region DR1, and the first source region SR1) having different characteristics. In one embodiment, oxygen vacancies may occur mainly at a part of the first active layer ACT1 that is not covered with the first gate insulating layer GI1, and may diffuse to a part of the region overlapping the first gate electrode GE1, the first dummy gate electrodes DG1 and/or the first gate insulating layer GI1. In one embodiment, when each first dummy gate electrode DG1 has the length Ld1 less than or equal to the first length corresponding to 2ΔL1, oxygen vacancies may diffuse to the entire region overlapping the first dummy gate electrode DG1 of the first active layer ACT1.

Similarly, mainly at a part that does not overlap the second gate electrode GE2 and the second dummy gate electrodes DG2, oxygen vacancies may occur in the second active layer ACT2. Accordingly, the second active layer ACT2 may be divided into a plurality of regions (e.g., the second channel region CH2, the second drain region DR2, and the second source region SR2) having different characteristics. In one embodiment, oxygen vacancies may occur mainly at a part of the second active layer ACT2 that is not covered with the second gate insulating layer GI2, and may diffuse to a part of the region overlapping the second gate electrode GE2, and the second dummy gate electrodes DG2, and/or the second active layer ACT2. In one embodiment, when each second dummy gate electrode DG2 has the length Ld2 less than or equal to the second length corresponding to 2ΔL2, oxygen vacancies may diffuse to the entire region overlapping the second dummy gate electrode DG2 of the second active layer ACT2.

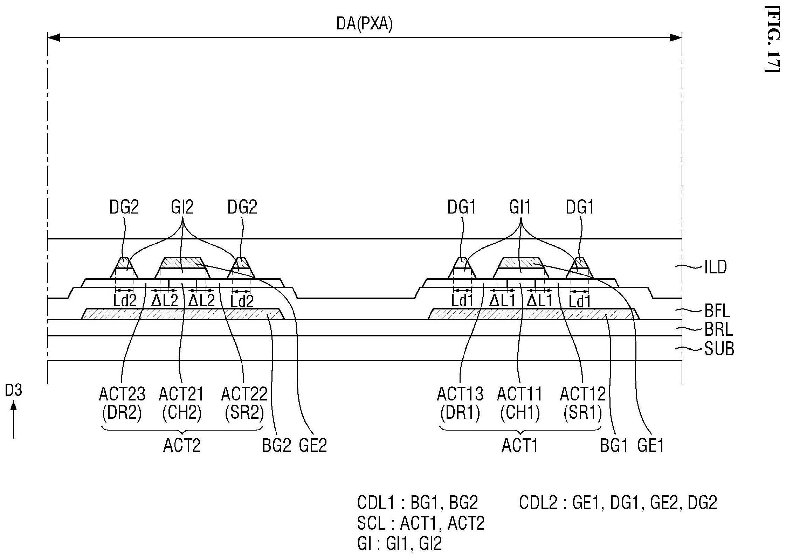

Referring to FIG. 17 in addition to FIGS. 1 to 16, the active layers ACT (e.g., the first and second active layers ACT1 and ACT2) provided in the semiconductor layer SCL, the insulating patterns (e.g., the first and second gate insulating layers GI1 and GI2) provided in the gate insulating layer GI, the gate electrodes GE (e.g., the first and second gate electrodes GE1 and GE2) provided in the second conductive layer CDL2, and the interlayer insulating layer ILD covering the dummy gate electrodes DG (e.g., the first and second dummy gate electrodes DG1 and DG2) may be formed. The interlayer insulating layer ILD may be formed through the film forming process of an insulating layer by using at least one insulating material (e.g., an inorganic insulating material) exemplified above. In one embodiment, after forming the interlayer insulating layer ILD, a subsequent process such as heat treatment may be performed. Materials and/or methods for forming the interlayer insulating layer ILD may be variously changed according to embodiments.

In the process of forming the interlayer insulating layer ILD, hydrogen may flow into the active layers ACT of the semiconductor layer SCL. For example, hydrogen may flow mainly into a part of the active layers ACT that is not covered with the gate electrodes GE and/or the dummy gate electrodes DG. Accordingly, the source region SE and the drain region DE of each of the active layers ACT may become conductive to have appropriate conductivity.

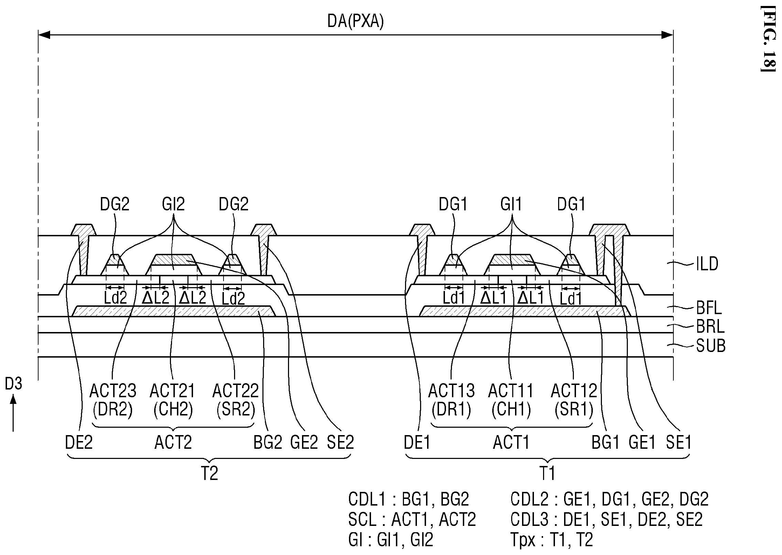

Referring to FIG. 18 in addition to FIGS. 1 to 17, the third conductive layer CDL3 including the source electrodes SE and the drain electrodes DE may be formed on the interlayer insulating layer ILD. For example, the first drain electrode DE1, the first source electrode SE1, the second source electrode SE2, and the second drain electrode DE2 may be formed on the interlayer insulating layer ILD. In one embodiment, at least one of the first drain region DR1, the first source region SR1, the second source region SR2, or the second drain region DR2 replaces at least one of the first drain electrode DE1, the first source electrode SE1, the second source electrode SE2, or the second drain electrode DE2, at least one of the first drain electrode DE1, the first source electrode SE1, the second source electrode SE2, or the second drain electrode DE2 may not be formed.

The first source electrode SE1 and the first drain electrode DE1 may be formed to be connected to different parts of the first active layer ACT1. For example, the first source electrode SE1 may be connected to the first source region SR1, and the first drain electrode DE1 may be connected to the first drain region DR1. The second source electrode SE2 and the second drain electrode DE2 may be formed to be connected to different parts of the second active layer ACT2. For example, the second source electrode SE2 may be connected to the second source region SR2, and the second drain electrode DE2 may be connected to the second drain region DR2. To this end, prior to the formation of the first drain electrode DE1, the first source electrode SE1, the second source electrode SE2, and the second drain electrode DE2, a plurality of contact holes may be formed in the interlayer insulating layer ILD.

Through the above-described process, a plurality of pixel transistors Tpx including the first transistor T1 and the second transistor T2 and the dummy gate electrodes DG may be formed in the display area DA. In one embodiment, elements provided on the same conductive layer or the same semiconductor layer SCL in the display panel 110 may be formed simultaneously.

After the pixel transistors Tpx are formed, a process of forming the passivation layer PSV shown in FIG. 6 or the like may be performed. The passivation layer PSV may cover the pixel transistors Tpx. Accordingly, the panel circuit layer PCL of the display panel 110 may be formed.

In one embodiment, when the display panel 110 includes the light emitting element layer LEL and the encapsulation layer ENL disposed on the panel circuit layer PCL, the light emitting element layer LEL and the encapsulation layer ENL may be sequentially formed on the panel circuit layer PCL. Through the above-described processes, the display panel 110 and the display device 100 including the same according to the embodiments may be manufactured.

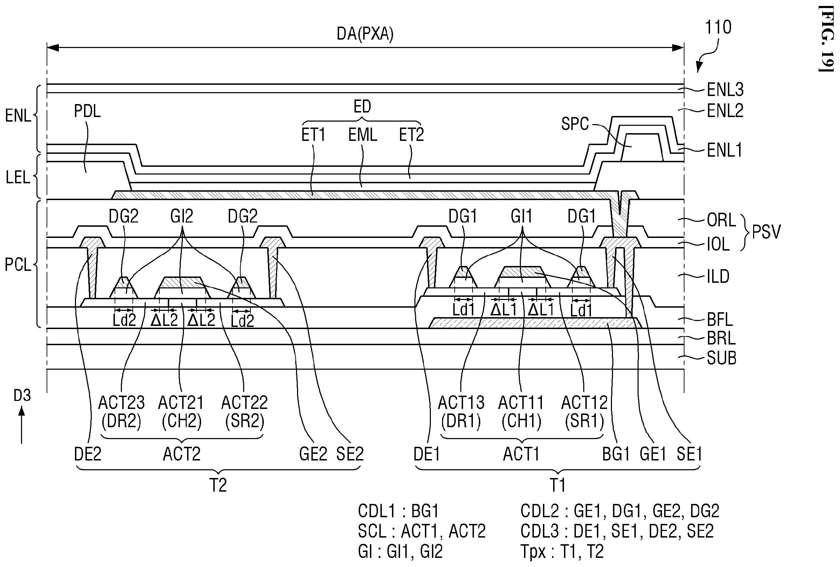

FIG. 19 is a cross-sectional view illustrating the display panel 110 according to one embodiment. For example, FIG. 19 shows an embodiment that is different from the embodiment of FIG. 6 in relation to the bottom gate electrode BG.

Although FIG. 19 shows a modified embodiment of the embodiment of FIG. 6, the embodiment of FIG. 19 may also be applied to other embodiments. For example, the embodiment of FIG. 19 may also be applied to at least one of the embodiments of FIGS. 7, 9, and 10.

Referring to FIG. 19 in addition to FIGS. 1 to 18, each pixel transistor Tpx or each switching transistor provided in the pixel PX may or may not include each bottom gate electrode BG. In one embodiment, at least one pixel transistor Tpx (e.g., a driving transistor) provided in the pixel PX may include the bottom gate electrode BG, and at least one other pixel transistor Tpx (e.g., at least one switching transistor) provided in the pixel PX may not include the bottom gate electrode BG. For example, the first transistor T1 may include the first bottom gate electrode BG1, and the second transistor T2 may not include the bottom gate electrode BG (e.g., the second bottom gate electrode BG2 of FIG. 6). As described above, the structure of the pixel PX in relation to the bottom gate electrode BG may be variously changed depending on embodiments.

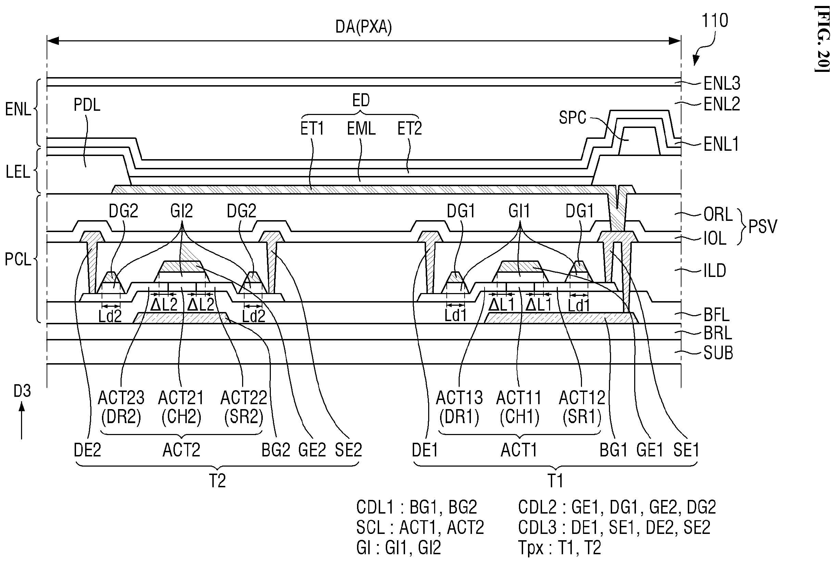

FIG. 20 is a cross-sectional view illustrating the display panel 110 according to one embodiment. For example, FIG. 20 shows an embodiment that is different from the embodiment of FIG. 6 in relation to the bottom gate electrode BG.

Although FIG. 20 shows a modified embodiment of the embodiment of FIG. 6, the embodiment of FIG. 20 may also be applied to other embodiments. For example, the embodiment of FIG. 20 may also be applied to at least one of the embodiments of FIGS. 7, 9, 10, and 19.

Referring to FIG. 20 in addition to FIGS. 1 to 19, the bottom gate electrode BG provided in the pixel transistor Tpx may not overlap at least one dummy gate electrode DG provided in the pixel transistor Tpx. For example, the second bottom gate electrode BG2 provided in the second transistor T2 may not overlap the second dummy gate electrodes DG2 provided in the second transistor T2. For example, the second bottom gate electrode BG2 may be disposed under the second active layer ACT2 to overlap the second gate electrode GE2, and may have a reduced width so as not to overlap the second dummy gate electrodes DG2. However, the embodiments are not limited thereto. For example, the second bottom gate electrode BG2 may overlap one of the second dummy gate electrodes DG2 and may not overlap another one of the second dummy gate electrodes DG2.

Similarly, the first bottom gate electrode BG1 provided in the first transistor T1 may not overlap at least one first dummy gate electrode DG1 provided in the first transistor T1. For example, the first bottom gate electrode BG1 may be disposed under the first active layer ACT1 to overlap the first gate electrode GE1, and may not overlap the first dummy gate electrode DG1 adjacent to the first drain electrode DE1. In one embodiment, the first bottom gate electrode BG1 may overlap the first dummy gate electrode DG1 adjacent to the first source electrode SE1. However, the embodiments are not limited thereto. For example, the first bottom gate electrode BG1 may extend to the position under the first source electrode SE1 while bypassing the region where the first dummy gate electrode DG1 adjacent to the first source electrode SE1 is disposed.

In addition, the shape, size, and/or location of the bottom gate electrode BG provided in each pixel transistor Tpx may be variously changed depending on embodiments.

Although the embodiments of the present invention have been described with reference to the attached drawings, those skilled in the art will understand that the present invention can be implemented in other specific forms without changing the technical idea or essential features of the present invention. Therefore, it should be understood that the embodiments described above are examples in all respects and not restrictive.

## Claims

1. A display device comprising:
a substrate;
a first transistor comprising a first active layer disposed on the substrate and comprising a first portion comprising a first channel region and a second portion and a third portion spaced apart from each other with the first portion interposed therebetween, and a first gate electrode disposed on the first portion of the first active layer;
at least one first dummy gate electrode disposed on a part of at least one of the second portion and the third portion of the first active layer and separated from the first gate electrode; and
a first gate insulating layer disposed between the first active layer and each of the first gate electrode and the at least one first dummy gate electrode.

2. The display device of claim 1, wherein the first gate insulating layer comprises an insulating pattern disposed between the first active layer and the first gate electrode, and exposes a part of each of the second portion and the third portion of the first active layer.

3. The display device of claim 2, wherein the first gate insulating layer further comprises at least one insulating pattern disposed between the at least one first dummy gate electrode and the first active layer.

4. The display device of claim 1, wherein the first active layer further comprises a first source region located in the second portion and located at a side of the first channel region, and a first drain region located in the third portion and located at another side of the first channel region, and
the first gate electrode covers at least the first channel region, and overlaps a part of the first source region and a part of the first drain region by a section corresponding to a first length in a longitudinal direction of the first active layer.

5. The display device of claim 4, wherein the first dummy gate electrode has a length less than or equal to the first length in the longitudinal direction of the first active layer.

6. The display device of claim 4, wherein the first dummy gate electrode has a length longer than the first length in the longitudinal direction of the first active layer, and
the first active layer further comprises at least one dummy channel region located in at least one of the second portion and the third portion and overlapping the first dummy gate electrode.

7. The display device of claim 6, wherein the first dummy gate electrode covers the dummy channel region, and overlaps a part of the first source region or a part of the first drain region around the dummy channel region.

8. The display device of claim 7, wherein the dummy channel region has a short channel whose length falls within a threshold voltage roll-off section of a dummy transistor comprising the first dummy gate electrode and the dummy channel region.

9. The display device of claim 7, further comprising a pixel comprising a plurality of pixel transistors comprising the first transistor,
wherein the dummy channel region has a length shorter than a length of a channel region of each of the plurality of pixel transistors.

10. The display device of claim 4, further comprising an interlayer insulating layer disposed on the substrate, and covering the first active layer, the first gate insulating layer, the first gate electrode and the at least one dummy gate electrode,
wherein the first transistor further comprises at least one of a first source electrode disposed on the interlayer insulating layer and electrically connected to the first source region, and a first drain electrode disposed on the interlayer insulating layer and electrically connected to the first drain region.

11. The display device of claim 1, further comprising a power line electrically connected to the first dummy gate electrode and to which a gate-on voltage of the first transistor is applied.

12. The display device of claim 1, further comprising a pixel comprising a pixel circuit comprising the first transistor and a light emitting element connected to the pixel circuit,
wherein the first transistor is a driving transistor which controls a driving current flowing to the light emitting element in response to a voltage applied to the first gate electrode.

13. The display device of claim 12, wherein the at least one first dummy gate electrode comprises a plurality of first dummy gate electrodes, the plurality of first dummy gate electrodes being located at both sides of the first gate electrode and disposed above each of the second portion and the third portion of the first active layer.

14. The display device of claim 12, wherein the pixel circuit further comprises a second transistor electrically connected to the first gate electrode, and
the second transistor comprises:
a second active layer disposed on the substrate, and comprising a first portion comprising a second channel region, a second portion located at a side of the second channel region and comprising a second source region, and a third portion located at another side of the second channel region and comprising a second drain region; and
a second gate electrode disposed on the first portion of the second active layer.

15. The display device of claim 14, wherein the pixel further comprises:
at least one second dummy gate electrode disposed on a part of at least one of the second portion and the third portion of the second active layer, and spaced apart from the second gate electrode; and
a second gate insulating layer comprising insulating patterns disposed between the second active layer and each of the second gate electrode and the at least one second dummy gate electrode.

16. The display device of claim 15, wherein the second gate insulating layer exposes a part of each of the second portion and the third portion of the second active layer, and
the second gate electrode covers at least the second channel region, and overlaps a part of each of the second source region and the second drain region around the second channel region.

17. The display device of claim 15, wherein the at least one second dummy gate electrode comprises a plurality of second dummy gate electrodes, the plurality of second dummy gate electrodes being located at both sides of the second gate electrode and disposed above each of the second portion and the third portion of the second active layer.

18. The display device of claim 15, wherein the second source region is electrically connected to the first gate electrode, and
the pixel comprises a single second dummy gate electrode disposed only on the second portion of the second active layer.

19. The display device of claim 14, wherein the first active layer and the second active layer contain an oxide semiconductor.

20. A method for manufacturing a display device, comprising:
forming an active layer containing an oxide semiconductor on a substrate;
forming a gate insulating layer covering the active layer on the substrate;
forming, on the gate insulating layer, a gate electrode and at least one dummy gate electrode which overlap different parts of the active layer and are separated from each other;
by etching the gate insulating layer, forming insulating patterns under each of the gate electrode and the at least one dummy gate electrode, and exposing a part of the active layer which does not overlap the gate electrode and the at least one dummy gate electrode; and
forming an interlayer insulating layer covering the active layer, the insulating patterns, the gate electrode and the at least one dummy gate electrode.
